# EUROPÄISCHE PATENTSCHRIFT

(11) **EP 2 856 848 B1**
(45) Veröffentlichungstag und Bekanntmachung des Hinweises auf die Patenterteilung: **25.05.2016**
(21) Anmeldenummer: 13726488.3
(22) Anmeldetag: 27.05.2013
(51) Int. Cl.: H05K 3/00

(54) **VERFAHREN UND ANLAGE ZUM HERSTELLEN EINES MEHRSCHICHTELEMENTS SOWIE MEHRSCHICHTELEMENT**
METHOD AND SYSTEM FOR PRODUCING A MULTILAYER ELEMENT AND MULTILAYER ELEMENT
PROCÉDÉ ET INSTALLATION POUR FABRIQUER UN ÉLÉMENT MULTICOUCHE ET ÉLÉMENT MULTICOUCHE

(30) Priorität: 01.06.2012 DE 102012209328
(43) Veröffentlichungstag der Anmeldung: 08.04.2015
(73) Patentinhaber: 3D-Micromac AG, 09126 Chemnitz (DE)
(72) Erfinder: PETSCH, Tino, 09127 Chemnitz (DE); CLAIR, Maurice, 08529 Plauen (DE); BÖHM, Alexander, 09496 Marienberg (DE); SACHSE, Martin, 04275 Leipzig (DE)
(74) Vertreter: Patentanwälte Ruff, Wilhelm, Beier, Dauster & Partner mbB
(86) Internationale Anmeldenummer: PCT/EP2013/060878
(87) Internationale Veröffentlichungsnummer: WO 2013/178588

(56) Entgegenhaltungen:
- EP-B1- 0 790 123
- WO-A1-2011/159716
- US-A1- 2001 044 013
- US-A1- 2006 216 861
- US-B1- 6 280 555

## Beschreibung

### HINTERGRUND

Die Erfindung betrifft ein Verfahren zum Herstellen eines Mehrschichtelements mit einem Substrat und mindestens einer mit dem Substrat flächig verbundenen Leiterstruktur gemäß dem Oberbegriff von Anspruch 1, eine Anlage zum Herstellen eines derartigen Mehrschichtelements gemäß dem Oberbegriff von Anspruch 8 sowie ein durch das Verfahren erhältliches Mehrschichtelement.

Ein bevorzugtes Anwendungsgebiet ist die Herstellung von Antennen für Radiofrequenz-Identifikationssysteme (RFID-Antennen) oder anderen mittels Laminierung herstellbaren Mehrschichtelementen mit leitfähigen Strukturen z.B. für elektrische Schaltungen unter Verwendung von flexiblen bandförmigen Substraten in einem Rolle-zu-Rolle-Verfahren.

Bei der Herstellung von elektrischen oder elektronischen Komponenten für Massenanwendungen ist man bestrebt, die gewünschte elektrische Funktionalität in guter Qualität bei möglichst geringen Herstellungskosten bereitzustellen. Bei einer Klasse von Herstellungsverfahren wird als Zwischenprodukt ein Laminat hergestellt, indem eine Leiterfolie, insbesondere eine Metallfolie, mit dem Substrat mittels einer zwischenliegenden Kleberschicht verbunden wird. Anschließend wird die Leiterfolie strukturiert, indem sie an den Grenzen derjenigen Bereiche, die später die Leiterstruktur bilden sollen, durch ein geeignetes Trennverfahren, beispielsweise Laserschneiden, Stanzen etc., durchtrennt wird. Dabei werden in vielen Fällen relativ große Folienstücke erzeugt, die nicht zum Endprodukt gehören und dementsprechend vom Zwischenprodukt entfernt werden müssen, bevor sich weitere Verfahrensschritte anschließen können.

Das europäische Patent EP 0 790 123 B1 bzw. die entsprechende DE 697 34 328 T2 beschreiben ein Verfahren zum Herstellen eines Laminats aus einer gemusterten Metallfolie und einem Substrat, bei dem eine Metallfolienbahn auf ein Substrat laminiert wird, indem ein Kleber zwischen die Metallfolie und das Substrat in einem vorbestimmten Muster eingebracht wird. Das Muster definiert Bereiche, in denen Kleber vorhanden ist sowie Bereiche, in denen kein Kleber vorhanden ist. Anschließend wird die Metallfolie in ein Muster geschnitten, das den Grenzen der den Kleber enthaltenden Bereiche entspricht. Das Schneiden kann beispielsweise mittels Rotationsstanzen oder durch Laserschneiden erfolgen. Diejenigen Bereiche von Metallfolie, die nicht mit dem Kleber auf das Substrat aufgeklebt sind, werden anschließend z.B. durch Absaugen entfernt.

Die WO 2009/11845 A1 offenbart andere gattungsgemäße Verfahren. Bei einer Verfahrensvariante wird eine Leiterfolie selektiv am Substratmaterial befestigt, wobei gewünschte Bereiche des Endprodukts, welche die finale Leiterstruktur bilden, sowie schmale Bereiche zwischen den leitenden Bereichen des Endprodukts, mittels eines Klebers mit dem Substrat verbunden werden und lateral ausgedehnte Bereiche der Folie, welche später beseitigt werden sollen, im Wesentlichen ohne Verbindung zum Substrat verbleiben derart, dass sie höchstens in einem Randbereich, der in einem späteren Strukturierungsschritt entfernt wird, mit dem Substrat verbunden sind. Anschließend wird die Leiterfolie durch Entfernen von Material von schmalen Bereichen zwischen den gewünschten Bereichen der Leiterstruktur sowie vom äußeren Rand der größeren Folienbereiche, die später am Stück entfernt werden sollen, durch Materialbeseitigung strukturiert, um die Leiterstruktur zu erzeugen. Danach werden die nicht mehr am Substrat befestigten Folienstücke entfernt, nachdem der Randbereich dieser Folienstücke, der während der Strukturierungsoperation vom äußeren Rand dieser Folienstücke entfernt wurde, die Folienstücke nicht mehr am Substrat festhält. Durch das Verfahren sollen u.a. Probleme vermieden werden, die sich ergeben, wenn Klebermaterial in den nicht leitenden Bereichen der fertigen Struktur verbleibt.

### AUFGABE UND LÖSUNG

Der vorliegenden Erfindung liegt die Aufgabe zugrunde, ein Verfahren und eine Anlage zum Herstellen eines gattungsgemäßen Mehrschichtelements der eingangs erwähnten Art bereitzustellen, die die Herstellung qualitativ hochwertiger Mehrschichtelemente mit hoher Prozesssicherheit bei niedrigen Herstellungskosten erlauben. Die hergestellten Endprodukte sollen gleichbleibend gute Funktionsfähigkeit auch unter mechanischer Beanspruchung während der Nutzung haben.

Zur Lösung dieser Aufgaben stellt die Erfindung ein Verfahren mit den Merkmalen von Anspruch 1 bereit. Weiterhin wird eine Anlage mit den Merkmalen von Anspruch 8 bereitgestellt. Vorteilhafte Weiterbildungen sind in den abhängigen Ansprüchen angegeben. Der Wortlaut sämtlicher Ansprüche wird durch Bezugnahme zum Inhalt der Beschreibung gemacht.

Bei dem Verfahren wird die Leiterfolie mit dem Substrat derart verbunden, dass die Leiterfolie in ersten Bereichen, welche im Endprodukt das gewünschte elektrisch leitende Leitermaterial aufweisen sollen, fest an dem Substrat haftet und in lateral ausgedehnten zweiten Bereichen, die am Endprodukt elektrisch nicht leitend sein sollen, ein partieller Haftkontakt zwischen dem Substrat und der Leiterfolie an einer Vielzahl von über den ausgedehnten zweiten Bereich verteilten Haftzonen erzeugt wird. "Haftzonen" sind in der Regel relativ kleinflächig und haben in mindestens einer in der Fläche liegenden Richtung einen lateralen Abstand zueinander. Zwischen Haftzonen liegen Zwischenbereiche, in denen keine Haftkraft oder nur stark verminderte Haftkraft im Vergleich zu den Haftzonen vorliegt. Die feste Haftung in den ersten Bereichen kann insbesondere dadurch erreicht werden, dass hier eine flächige, ununterbrochene Verbindung zwischen Substrat und Leiterfolie hergestellt wird.

Danach wird die Leiterfolie durch Schneiden bzw. Trennen der Leiterfolie entlang von Grenzen der ersten Bereiche strukturiert, wodurch aus der vorher zusammenhängenden Leiterfolie diejenigen Bereiche herausgearbeitet werden, die am fertigen Produkt die gewünschte Leiterstruktur bilden. Bei dieser Strukturierungsoperation verbleiben Folienstücke der Leiterfolie in lateral ausgedehnten zweiten Bereichen, die an die Bereiche mit Leiterstruktur angrenzen. Diese Folienstücke haften in den lateral ausgedehnten zweiten Bereichen zunächst noch im Bereich der nach einem vorgegebenen Muster verteilten Haftzonen am Substrat bzw. der Kleberschicht. Die Folienstücke werden nach der Strukturierungsoperation aus den lateral ausgedehnten zweiten Bereichen entfernt, wobei der partielle Haftkontakt zwischen dem Substrat und der Leiterfolie im Bereich der Haftzonen aufgelöst wird.

Ein "lateral ausgedehnter zweiter Bereich" im Sinne dieser Anmeldung hat typischerweise in mehrere Richtungen eine Ausdehnung, die um ein Vielfaches größer ist als die Schnittbreite der Strukturierungsoperation, z.B. mindestens 10 mal oder mindestens 100 mal oder mindestens 1000 mal so groß. Die Ausdehnung lateral ausgedehnter Bereiche kann z.B. an der schmalsten Stelle mindestens 1 mm betragen und/oder an der breitesten Stelle mindestens 10 mm. Lateral ausgedehnte zweite Bereiche können z.B. bei in Umfangsrichtung geschlossenen Leiterstrukturen, wie sie für Antennen oder Spulen gelegentlich genutzt werden, im Inneren der Leiterstruktur liegen. Auch zwischen Leiterstrukturen, die auf demselben Substrat mit Abstand zueinander benachbart liegen, können größere lateral ausgedehnte zweite Bereiche liegen. In der Regel gibt es auch zweite Bereiche kleinerer lateraler Dimensionen, z.B. zwischen eng benachbart verlaufenden Leiterbahnen der Leiterstruktur. In diesen zweiten Bereichen kann das Leitermaterial bereits bei der Strukturierungsoperation entfernt werden, z.B. durch Laserablation (Materialabtrag mittels Laserstrahlung).

Bei der vorgeschlagenen Verfahrensführung können Probleme, die sich durch undefiniertes Ablösen von nicht benötigten Folienstücken ergeben, zuverlässig vermieden werden. Bei der Fertigung gattungsgemäßer Mehrschichtelemente nach bekannten Laminierungsverfahren hat es sich gelegentlich als schwierig erwiesen, das überflüssige Folienmaterial sauber und ohne Beeinträchtigung des Fertigungsablaufs zu entfernen. Insbesondere konnte es schwierig sein, das Leitermaterial, wie z.B. eine Metallfolie, an genau definierter Position in der Prozesskette zu einem genau definierten Zeitpunkt während des Prozessablaufs zu entfernen. Ein unkontrolliiertes Ablösen von Folienstücken birgt unter anderem das Risiko, dass der Rand der zu entfernenden Folienstücke bei der Strukturierung ausfranst oder noch zu bearbeitende Bereiche überdeckt und damit der Herstellungsprozess gestört wird. Derartige Probleme werden beim Verfahren gemäß der beanspruchten Erfindung vermieden, da in den lateral ausgedehnten zweiten Bereichen, die am fertigen Produkt kein Leitermaterial mehr aufweisen sollen, die Leiterfolie zunächst noch an den Haftzonen mit dem Substrat verbunden bleibt.

Der partielle, lokal begrenzte Haftkontakt an vielen verteilten Stellen innerhalb der ausgedehnten zweiten Bereiche bewirkt eine gut definierbare endliche Haltekraft, mit der freigeschnittene Folienstücke zunächst noch am Substrat festgehalten werden. Diese Haltekraft kann durch Vorgabe von Anzahl, Größe, Form und/oder Verteilung der Haftzonen innerhalb der zweiten Bereiche in weiten Grenzen an den aktuellen Prozess angepasst werden, um sicherzustellen, dass die Haltekraft in dem zweiten Bereich deutlich geringer ist als diejenige Haltekraft, mit der die Leiterfolie in ersten Bereichen zur Bildung der Leiterstruktur am Substrat haftet. Ein zufälliges Ablösen freigeschnittener Folienstücke oder eine Verlagerung derartiger Folienstücke noch während der Strukturierung der Leiterfolie werden dadurch zuverlässig vermieden. Erst wenn beim späteren Entfernen der Folienstücke ausreichend starke Kräfte auf die Folienstücke wirken, können diese von den Haftzonen gelöst und somit freigegeben werden. Durch das partielle Festhalten der freigeschnittenen Folienstücke an den Haftzonen in den ausgedehnten zweiten Bereichen wird auch sichergestellt, dass das Material nicht vor dem Schritt der definierten Entfernung vom Substrat undefiniert in die Anlage geraten und dort gegebenenfalls Störungen verursachen kann.

Bei Ausführungsformen, bei denen zum Verbinden von Substrat und Leiterfolie eine zwischenliegende Kleberschicht verwendet wird, ist es auch möglich, laminierte Mehrschichtelemente (Laminate) herzustellen, die sowohl in den Bereichen der Leiterstruktur, als auch in den elektrisch nicht leitenden zweiten Bereichen eine für die vorgesehene Verwendung ausreichende mechanische Belastbarkeit aufweisen. Bei herkömmlich hergestellten Laminaten kann es sein, dass die elektrisch nicht leitenden zweiten Bereiche am Endprodukt mechanisch deutlich weniger stabil und belastbar sind als diejenigen ersten Bereiche, in denen die Leiterstruktur am Substrat haftet. Als Folge können sich Schwierigkeiten bei der Weiterverarbeitung ergeben. Wird beispielsweise ein Transponderelement mit einer flexiblen RFID-Antenne an einem Kleidungsstück befestigt, so birgt der weniger stabile Bereich ohne Leiterstruktur in der Regel das höchste Risiko für dauerhafte, dynamische Materialermüdung mit der Folge einer Rissbildung oder Bruch und schließlich gegebenenfalls Funktionsunfähigkeit der RFID-Antenne. Dadurch kann sich eine eingeschränkte Lebensdauer ergeben. Wenn dagegen am fertigen Produkt in den zweiten Bereichen noch Bereiche mit Kleberschicht vorhanden sind, kann sich dadurch eine mechanische Stabilisierung der zweiten Bereiche ergeben.

Das Verfahren kann so durchgeführt werden, dass die Haftzonen in lateralen ausgedehnten zweiten Bereichen ein gleichmäßiges oder ungleichmäßiges Punktemuster oder ein gleichmäßiges oder ungleichmäßiges Linienmuster bilden. Die räumliche Verteilung von Haftzonen ist bei zahlreichen Varianten im Wesentlichen gleichmäßig, kann aber auch ungleichmäßig sein, so dass sich beispielsweise zwischen Bereichen höherer räumlicher Dichte von Haftzonen leichter abzulösende Bereiche geringer Dichte von Haftzonen befinden. Häufig haben die Haftzonen in mindestens eine Richtung eine laterale Ausdehnung, die geringer ist als der laterale Abstand benachbarter Haftzonen in der entsprechenden Richtung. Punktförmige Haftzonen sind nicht im mathematischen Sinne punktförmig, sondern haben eine laterale Ausdehnung und eine entsprechende Position, um innerhalb der zweiten Bereiche die gewünschte Haftkraft lokal bereitzustellen. Punktförmige Haftzonen sind in Umfangsrichtung allseitig von nicht oder nur gering haftfähigen Zwischenbereichen umgeben. Punktförmige Haftzonen können beispielsweise einen runden, ovalen oder polygonalen Querschnitt haben. Linienförmige Haftzonen können parallel zueinender liegen oder sich überkreuzen, um z.B. ein gitterartiges Rechteckmuster oder ein Rautenmuster zu bilden. Die Linienbreite linienförmiger Haftzonen kann gleichmäßig sein oder entlang der Linie variieren. Der Flächenanteil der Haftzonen innerhalb der lateral ausgedehnten Bereiche, d.h. das Verhältnis zwischen der Gesamtfläche der Haftzonen in einem lateral ausgedehnten zweiten Bereich und der Gesamtfläche des lateral ausgedehnten zweiten Bereichs kann je nach Bedarf eingestellt werden. Bei typischen Ausführungsformen liegt der Flächenanteil zwischen ca. 2% und ca. 80%, insbesondere zwischen ca. 5% und ca. 50%. Die Gesamtfläche der nicht oder schlecht haftenden Zwischenbereiche ist also in der Regel größer als derjenige der Haftzonen.

Bei bevorzugten Ausführungsformen wird die Leiterfolie mit dem Substrat mittels einer zwischenliegenden Kleberschicht verbunden wird. Eine entsprechende Anlage hat hierzu mindestens eine Kleberauftragseinrichtung. Die Verbindung mittels Kleber bzw. Klebstoff ist in vielen Fällen für Substrat und Leiterfolie besonders schonend. Außerdem kann die Verbindungsherstellung in der Regel relativ kostengünstig mit hoher Produktivität erfolgen. Alternativ oder zusätzlich können geeignete andere Verbindungstechniken genutzt werden.

Es gibt unterschiedliche Möglichkeiten für die Erzeugung der Kleberschicht.

Bei manchen Ausführungsformen wird vor dem Verbinden der Leiterfolie mit dem Substrat eine lateral strukturierte Kleberschicht auf das Substrat oder auf die Leiterfolie aufgetragen, wobei Kleber in den ersten Bereichen vollflächig und in lateral ausgedehnten zweiten Bereichen zur Erzeugung der Haftzonen partiell nach einem vorgegebenen Muster aufgetragen wird. Zwischen den Bereichen, die die Haftzonen bilden, wird kein Kleber aufgetragen, so dass dort die Leiterfolie bzw. das Substrat beim Kleberauftrag frei von Kleber bleibt. Diese Verfahrensweise zeichnet sich durch besonders geringen Kleberverbrauch aus.

Zur Erzeugung einer lateral strukturierten Kleberschicht kann z.B. ein Strahldruckverfahren analog dem Tintenstrahldruck (ink-jet-Druck) eingesetzt werden. Dieses digitale Druckverfahren bietet hohe Flexibilität bei der Gestaltung des aufzubringenden lateral strukturierenden Klebermusters und kann besonders bei Verwendung niedrigviskoser Kleber genutzt werden. Kleber können gegebenenfalls hierzu verdünnt werden. Ein Klebstoffmuster kann auch durch ein Flexodruckverfahren aufgebracht werden, also durch ein Rollenrotationsdruckverfahren, bei dem eine flexible Druckplatte mit erhabenem Muster zum Kleberauftrag- verwendet werden kann. Die flexible Stempelrolle rollt auf dem Bedruckstoff (Substrat oder Leiterfolie) ab und erzeugt dabei das gewünschte Klebermuster. Diese Verfahrensvariante des Kleberauftrags kann besonders bei Serien mit sehr großen Stückzahlen wirtschaftlich vorteilhaft sein. Alternativ kann der Kleber auch durch ein Siebdruckverfahren oder ein Offsetdruckverfahren mit geeigneter lateraler Verteilung aufgebracht werden, gegebenenfalls auch durch Slot-Dye-Coating oder durch Tiefdruckverfahren, z.B. Gravure printing.

Als Alternative oder zusätzlich zur direkten Erzeugung einer lateral strukturierten Kleberschicht ist bei anderen Verfahrensvarianten vorgesehen, dass vor dem Verbinden der Leiterfolie mit dem Substrat in einer ersten Teiloperation (Kleberauftragoperation) eine Kleberschicht vollflächig, d.h. in den ersten und den zweiten Bereichen, auf das Substrat oder die Leiterfolie aufgetragen wird und danach in einer zweiten Teiloperation innerhalb der lateral ausgedehnten zweiten Bereiche zwischen den vorgesehenen Haftzonen durch eine Nachbehandlung Zwischenbereiche der Kleberschicht mit verminderter Haftkraft oder ohne Haftkraft erzeugt werden.

Hierzu wird bei manchen Verfahrensvarianten in den Zwischenbereichen zwischen den Haftzonen lokal begrenzt eine Abdeckschicht als weitere Schicht auf die Kleberschicht oder die korrespondierende Position an der Oberfläche der Leiterfolie nach einem vorgegebenen Muster aufgetragen. Beispielsweise können die zwischen den Haftzonen liegenden Bereiche mit einem Lack, beispielsweise einem UV-Lack, oder einer Tinte, z.B. einer UV-Tinte, abgedeckt werden. Das Material der lateral strukturierten Abdeckschicht kann durch ein geeignetes Druckverfahren, beispielsweise ein Strahldruckverfahren oder ein Flexodruckverfahren, in dem gewünschten Muster aufgebracht werden.

Es ist auch möglich, den Kleber in den Zwischenbereichen zwischen den Haftzonen zur Reduzierung der Haftkraft durch Einwirkung entsprechender Mittel chemisch und/oder physikalisch so umzuwandeln, dass die Haftkraft reduziert wird. Beispielsweise können die Zwischenbereiche mittels Laser oder mittels anderer elektromagnetischer Strahlung bestrahlt werden. Beispielsweise ist es möglich, mittels Laserstrahlung den Kleber bereichsweise (lokal) in seiner Klebekraft zu verringern, indem die eingebrachte thermische Energie eine chemische Umwandlung des Klebstoffs verursacht. Alternativ oder zusätzlich können die Zwischenbereiche auch lokal chemisch behandelt werden, z.B. mit einem flüssigen oder festen Stoff wie einer Tinte, einem Pulver oder dergleichen.

Es ist auch möglich, die Zwischenbereiche zwischen den Haftzonen mechanisch, mittels Laser oder auf andere Weise teilweise oder ganz zu entfernen, so dass von einer ursprünglichen vollflächigen Kleberschicht nur die Bereiche der Haftzonen für den Klebekontakt übrig bleiben. Das Klebermaterial kann beispielsweise in den Zwischenbereichen durch Laserablation abgetragen werden. Es kann z.B. bereichsweise die Dicke der Kleberschicht so reduziert werden, dass zwar eine vollflächige Kleberschicht vorhanden bleibt, bei der jedoch aufgrund der unterschiedlichen, lokal variierenden Dicke die Klebkraft entsprechend verschieden stark ausgeprägt ist.

Bei Verwendung eines Klebers, der erst durch Einwirkung äußerer Einflüsse, z.B. Bestrahlung mit UV-Strahlung, von einem nicht oder schwach klebenden Zustand in einen Zustand mit großer Haftkraft umgewandelt werden müssen, können die Haftzonen auch dadurch erzeugt werden, dass zunächst der zunächst noch inaktive oder nur schwach klebende Kleber vollflächig aufgetragen wird und dann nur die Bereiche der Haftzone lokal durch entsprechende Einwirkung aktiviert werden.

Bei manchen Verfahrensvarianten erfolgt nach dem Kleberauftrag oder einer Nachbehandlung der Kleberschicht eine Trocknungsoperation, um beispielsweise einen relativ flüssigen Kleber schnell in einen für die Weiterverarbeitung günstigeren höherviskosen Zustand zu überführen und/oder um eine später aufgetragene Tinte, einen Lack oder eine andere Abdeckflüssigkeit zu trocknen. Bei der Trocknungsoperation kann beispielsweise Ultraviolettstrahlung und/oder Infrarotstrahlung auf die Kleberschicht eingestrahlt werden. Es ist auch möglich, die Kleberschicht und/oder eine nur in den Zwischenbereichen aufgetragene Abdeckschicht mittels Mikrowellen und/oder mittels Temperaturerhöhung oder durch Verdampfen von flüchtigen Bestandteilen mittels Unterdruck (Vakuumtrocknen) zu trocknen.

In einer nachfolgenden Laminieroperation kann dann die Leiterfolie mit dem Substrat flächig verbunden werden. Die lateral strukturierte Kleberschicht kann sich dabei an der dem Substrat zugewandten Seite der Leiterfolie oder an der der Leiterfolie zugewandten Seite des Substrats befinden. Es wäre auch möglich, dass einige Flächenanteile einer strukturierten Kleberschicht an einer der Komponenten (Leiterfolie oder Substrat) angebracht sind, während andere Teilbereiche an der anderen Komponente angebracht sind, wobei sich dann die jeweiligen Teilschichten beim Laminieren zur gewünschten Kleberschicht ergänzen.

Um die aufeinanderfolgenden Verfahrensschritte während der Herstellung strukturierter Laminate möglichst ohne Positionierungsfehler durchführen zu können, können Registermarken an geeigneter Stelle des Substrats, beispielsweise links und/oder rechts des später mit Leiterfolie zu laminierenden Bereichs angebracht werden. Registermarken können beispielsweise durch Drucken, Lasern, Einritzen oder dergleichen erzeugt werden. Bei einer Verfahrensvariante werden aus Kleber bestehende Anteile von Registermarken gleichzeitig mit dem Kleberauftrag auf dem Substrat erzeugt. Wenn solche Anteile von Registermarken im gleichen Prozessschritt wie der Kleber aufgebracht werden, kann die relative Position der Kleberzonen zu den Registermarken besonders exakt vorgegeben werden, was sich positiv auf die Positionsgenauigkeit der später zu fertigenden Strukturen auswirkt. Die Registermarken können beispielsweise so erzeugt werden, dass ein Druckwerk zum Auftragen des Klebers für das Laminieren gleichzeitig zum Drucken von Anteilen der Registermarken genutzt wird. Diese klebenden Anteile von Registermarken können anschließend mindestens einem weiteren Behandlungsschritt unterzogen werden, um den Kleber zu deaktivieren und/oder für eine spätere optische Erfassung der Registermarken sichtbar zu machen. Beispielsweise kann der klebende Anteil der Registermarken nachträglich mit farbigem Pulver oder Toner bestreut oder bestrichen werden. Die aufgebrachten Partikel können im Bereich des Klebers haften, seine klebenden Eigenschaften binden und gleichzeitig den notwendigen Kontrast für eine spätere optische Erkennung, beispielsweise mittels einer Kamera, liefern.

Für die Strukturierung der Leiterfolie können unterschiedliche Trennverfahren bzw. Schneidverfahren genutzt werden, beispielsweise Stanzverfahren oder mechanische Schneideverfahren. Vorzugsweise erfolgt das Strukturieren der Leiterfolie durch Einstrahlen von Laserstrahlung entlang der Grenzen der zweiten Bereiche, also durch ein geeignetes Verfahren der Laserbearbeitung. In solchen Fällen umfasst die Anlage ein entsprechendes Laserbearbeitungssystem. Es kann sich z.B. um ein Scannersystem oder ein Maskenprojektionssystem handeln.

Ein Problem bei der Laserbearbeitung besteht darin, einen Laserstrahl unter unterschiedlichen Betriebsbedingungen möglichst positionsgenau und mit definierter Strahlqualität auf die jeweils zu bearbeitenden Oberflächenbereiche einzustrahlen. Dies ist besonders schwierig bei während der Bearbeitung bewegten Substraten, z.B. bei Rolle-zu-Rolle-Verfahren. Bei Fehlern in der Positioniergenauigkeit kann es sein, dass die zu erzeugenden Leiterstrukturen die gewünschte Gestalt nicht mit der erforderlichen Genauigkeit haben. Da abhängig vom Systemaufbau Positioniertoleranzen in der Regel nicht völlig vermeidbar sind und es auch vorkommen kann, dass der Laserstrahl z.B. durch thermische Erwärmung von Komponenten zur Strahlführung und Strahlformung im Laufe der Zeit wegdriftet, sollten Positionsabweichungen möglichst während des Prozesses (in process, on-the-fly) erfasst und gegebenenfalls kompensiert werden. Bei einer Ausführungsform ist hierzu eine Selbstkalibrierung des Laserbearbeitungssystems mit folgenden Schritten vorgesehen: Erzeugen mindestens einer Lasermarkierung im Bereich einer auf dem Substrat angebrachten Registermarke; Ortsauflösende Erfassung des Bereichs der Registermarke und der Lasermarkierung zur Bestimmung einer relativen Abweichung der Lasermarkierung zu der Registermarke; Bestimmen mindestens eines Abweichungsparameters, der die relative Position der Lasermarkierung zu der Registermarke repräsentiert; und Steuern des Laserbearbeitungssystems unter Berücksichtigung des Abweichungsparameters. Zur ortsauflösenden Erfassung kann z.B. ein Bild der Bereichs erzeugt und ausgewertet werden.

Es können also während des Herstellungsschritts der Laserbearbeitung zur Strukturierung der Leiterfolie zusätzlich in vorhandene Registermarken eine oder mehrere weitere Lasermarkierungen eingelasert werden. Mit Hilfe einer Kamera oder eines anderen ortsauflösenden Erfassungssystems kann derjenige Bereich, der die Registermarke und die Lasermarkierung enthält, erfasst werden, um die relative Positionierung zwischen Registermarke und Lasermarkierung z.B. mit Mitteln der Bildverarbeitung feststellen zu können. Anhand dieser Daten können eventuelle Abweichungen errechnet und in Form mindestens eines Abweichungsparameters zur Weiterverarbeitung zur Verfügung gestellt werden. In Abhängigkeit von dem Abweichungsparameter kann das Lasersystem dann gesteuert werden, beispielsweise indem Korrekturwerte für die Laserbearbeitung errechnet und die Komponenten des Laserbearbeitungssystems entsprechend zur Korrektur eventueller Positionierfehler angesteuert werden.

Nach Abschluss der Strukturierungsoperation werden die Folienstücke aus den lateral ausgedehnten zweiten Bereichen mittels einer Reinigungseinrichtung durch eine Reinigungsoperation entfernt. Dabei muss der partielle, lokal begrenzte und auf viele Stellen verteilte Haftkontakt zwischen den Folienstücken und dem Substrat im Bereich der Haftzonen aufgelöst werden. Die Reinigung kann z.B. mittels Druckluft oder Absaugen erfolgen. Alternativ oder zusätzlich kann zur Reinigung eine mit Borsten besetze Walze oder eine andere Reinigungsbürste verwendet werden.

Eine besonders sichere und saubere Reinigung wird bei manchen Ausführungsformen dadurch erreicht, dass die Folienstücke aus lateral ausgedehnten zweiten Bereich dadurch entfernt werden, dass die Folienstücke an eine Außenfläche eines bewegten Förderelements übertragen und mittels des Förderelements von den Haftzonen abgelöst und zur Weiterverarbeitung abtransportiert werden. Bei der Übertragung auf das Förderelement wirken auf die Folienstücke anziehende Kräfte, die in der Lage sind, die von den Haftzonen ausgeübten Kräfte zu überwinden. Das Förderelement hat dabei eine Doppelfunktion, indem einerseits zwischen dem Förderelement und den Folienstücken die für das Ablösen notwendigen anziehenden Kräfte wirken und indem andererseits die Folienstücke mit Hilfe des Förderelements kontrolliert abtransportiert werden können. Dadurch kann vermieden werden, dass beim Abreinigen lose Folienstücke unkontrolliert herumfliegen und den Betrieb der Anlage stören könnten.

Bei dem Förderelement kann es sich beispielsweise um eine Förderwalze handeln, deren zylindrische Außenfläche im Betrieb in Abrollkontakt mit dem bewegten Laminat steht. Das Förderelement kann z.B. auch ein endlos umlaufendes Förderband sein. Die Bewegungsrichtung der Außenfläche des Förderelements kann parallel zur Bewegungsrichtung des abzureinigenden Laminats sein oder schräg dazu verlaufen. Eine Reinigungseinrichtung kann ein einziges Förderelement aufweisen, ggf. aber auch zwei, drei oder mehr unabhängig oder koordiniert arbeitende Förderelemente.

Ein besonderes schonendes kontrolliertes Ablösen mit definierbarer Abzugskraft ergibt sich bei manchen Verfahrensvarianten dadurch, dass die Folienstücke durch Erzeugung eines Unterdrucks zwischen den Folienstücken und der Außenfläche des Förderelements in einem Ansaugabschnitt an die Außenfläche angesaugt und danach beim Weitertransport zunächst an dieser gehalten werden.

Vorzugsweise werden die an der Außenfläche angesaugten Folienstücke dann durch das Förderelement in den Bereich eines Freigabeabschnitts transportiert und im Freigabeabschnitt durch Erzeugung eines Überdrucks zwischen der Außenfläche und den Folienstücken aktiv von dem Förderelement freigegeben. Die an geeigneter Stelle freigegebenen Folienstücke können dann z.B. in einem Sammelbehälter fallen oder durch einen Luftstrom weiter befördert werden, der beispielsweise durch Absaugen oder Wegblasen erzeugt werden kann. Die Reinigung mittels Unterdruck ist hinsichtlich der zum Ablösen der Folienstücke wirksamen Kräfte besonders gut steuerbar und für die gereinigten Produkte schonend.

Dieses Reinigungsprinzip wird bei manchen Ausführungsformen technisch umgesetzt durch Verwendung einer Reinigungseinrichtung, die ein mittels seines Antriebs bewegbares Förderelement mit einer zum Zusammenwirken mit den Folienstücken vorgesehenen Außenfläche sowie eine Einrichtung zur Erzeugung eines Unterdrucks zwischen der Außenfläche und den Folienstücken aufweist. Das Förderelement kann hierzu von der Außenfläche zu einer Innenfläche durchgehende Gasdurchlasskanäle aufweisen. Diese können z.B. dadurch gebildet sein, dass in ein an sich gasundurchlässiges Grundmaterial Perforationen bei der Fertigung eingebracht werden. Es ist auch möglich, zur Herstellung des Förderelements offenporöses Material zu verwenden, so dass sich eine ausreichende Gasdurchlässigkeit ergibt.

Bei manchen Ausführungsformen hat die Reinigungseinrichtung eine Reinigungswalze mit einer hülsenförmigen Außenwalze, die einen ggf. feststehenden Walzenkern umschließt und gegenüber diesem mittels eines Antriebs gedreht werden kann. Die Außenwalze kann aus einem offenporösen Material bestehen, beispielsweise aus einer mikroporösen Sinterkeramik oder einem Metallschaum. Die Außenwalze kann auch eine metallische oder keramische Hülse aus einem gasundurchlässigen Material aufweisen, in der nach einem vorbestimmten Muster radiale Gasdurchlasskanäle eingebracht sind.

Im Inneren der Außenhülse, insbesondere im Walzenkern, kann sich ein Druckkammersystem befinden, welches über Kammern verfügt, die über geeignete Anschlüsse an eine Pumpe angeschlossen oder anschließbar sind, um Unterdruck oder Überdruck in einer Druckkammer zu erzeugen. Die Druckkammern sind zur Außenwalze hin offen und gegenüber dieser an den Rändern abgedichtet, so dass die Außenwalze in einem Ansaugabschnitt eine ansaugende Wirkung auf die Folienstücke ausüben kann und in einem Freigabeabschnitt der Überdruck in der zugeordneten Druckkammer zu einer abstoßenden Wirkung zwischen der Außenwalze und den anhaftenden Folienstücken führt.

Werden die Druckkammern einer solchen Walze ausschließlich mit Überdruck versorgt, so eignet sich die Walze auch für einen berührungslosen Transport oder eine Umlenkung des Materials an der Walze. Durch Steuerung des Überdrucks in den einzelnen Druckkammern können die durch das Bandgewicht oder die Bandumlenkung wirkenden Kräfte sowie dynamische Kräfte kompensiert werden. Dabei kann der Überdruck bereichsspezifisch über den Walzenumfang gesteuert werden.

Als Alternative zu einer rotationssymmetrischen Walze, oder zusätzlich dazu, könnte auch ein zwischen Umlenkrollen endlos umlaufendes Förderband als Förderelement dienen.

Bei manchen Ausführungsformen wird ein Förderelement verwendet, welches mittels einer Aufladeeinrichtung elektrostatisch aufgeladen wird, so dass sich mindestens ein Teil der vom Förderelement auf die Folienstücke wirkenden Anziehungskräfte aus elektrostatischen Anziehungskräften ergibt. Die elektrostatische Aufladung kann beispielsweise alternativ zur Erzeugung von Unterdruck oder zusätzlich dazu eingesetzt werden. Wenn beispielsweise das poröse und/oder mit Kanälen durchsetzte Material über einen ausreichenden Anteil von leitfähigem Material verfügt oder mit einer geeigneten Beschichtung versehen ist, kann ein solches Förderelement zusätzlich elektrostatisch aufgeladen werden, um neben der Ansaugkraft zusätzlich eine elektrostatische Anziehungskraft auf die zu entfernenden Folienstücke auszuüben. Dadurch können dieses gegebenenfalls leichter angehoben werden, um schließlich leichter angesaugt werden zu können.

Somit ist eine reine oder zumindest unterstützend wirkende elektrostatische Reinigung möglich. Hierfür können die zu entfernenden Folienstücke z.B. auf kurze Entfernung, typischerweise zwischen ca. 0,5 mm und 5 mm, bevorzugt im Zusammenwirken mit der Schwerkraft elektrostatisch auf ein Förderelement in Form eines aufgeladenen Bandes aus Polymer, Metall oder einem anderen geeigneten Material, angezogen und abtransportiert werden. Das als Förderelement dienende Band kann sowohl gleich laufend als auch quer laufend zu der Substratbahn verlaufen. Die elektrostatische Aufladung kann z.B. bei Polymerband mittels Bürsten oder anderer bekannter technischer Verfahren erfolgen. Die elektrostatische Aufladung von elektrisch leitfähigem Reinigungsband, z.B. aus Metall, kann beispielsweise über Spannungsversorgung und Isolation des Metallbandes gegenüber Erde erfolgen.

Weiterhin ist es möglich, zum Entfernen von Folienstücken aus lateral ausgedehnten zweiten Bereichen Schwingungsenergie in das Laminat einzuleiten. Beispielsweise ist eine Ultraschallreinigung möglich. Dabei werden die zu entfernenden Folienstücke mit Hilfe von Ultraschallschwingungen und/oder anderen geeigneten Vibrationen zumindest teilweise oder unterstützend von den Haftzonen losgelöst. Die Ultraschallschwingungen können z.B. über mechanische Verbindung in das Substrat oder die zu entfernende Folienbahn eingeleitet oder über kurze Abstände per Ultraschallschwingung in Form von Ultraschallwellen berührungslos durch Luft oder ein anderes Gas übertragen werden. Das Ablösen der Folienstücke von den Haftzonen wird dann durch die Schwingungsenergie, gegebenenfalls in Resonanz, realisiert oder zumindest unterstützt. Vorzugsweise wird eine Ultraschallreinigung unterstützend mit einem anderen Reinigungsverfahren in Kombination eingesetzt. Dadurch kann sich gegebenenfalls ein stabilerer und schnellerer Reinigungsprozess ergeben.

Es ist auch möglich, das bewegte Förderelement an seiner Außenfläche mit einem fluiden Haftfilm zu versehen, der die Adhäsionskräfte zwischen der Außenseite des Förderelements und den abzulösenden und abzutransportierenden Folienstücken erhöht. Der Haftfilm kann beispielsweise ein Flüssigkeitsfilm sein, der z.B. aus Wasser oder einer wasserhaltigen Flüssigkeit besteht. Es kann sich auch um eine polymere Flüssigkeit wie beispielsweise ein Flüssigklebstoff handeln.

Die in dieser Anmeldung beschriebenen Maßnahmen zur Abreinigung der strukturierten Laminate, d.h. zum Entfernen der Folienstücke der Leiterfolie, können unabhängig von den sonstigen Verfahrensschritten auch bei anderen gattungsgemäßen Verfahren und anderen Anlagen zur Herstellung strukturierte Laminate verwendet werden. Beispielsweise können diese Maßnahmen oder eine entsprechende Reinigungseinrichtung bei Anlagen und Verfahren des Standes der Technik verwendet werden, wie sie beispielsweise in den eingangs genannten Druckschriften (EP 0 790 123 B1 oder WO 2009/118455 A1) beschrieben ist. Entsprechendes gilt auch für die Herstellung von Registermarken unter Verwendung von klebenden Anteilen, die gleichzeitig mit dem Kleberauftrag auf das Substrat (oder die Leiterfolie) aufgebracht werden und für die in der vorliegenden Anmeldung beschriebene Vorgehensweise zur Selbstkalibrierung eines Laserbearbeitungssystems, bei dem eine oder mehrere Lasermarkierungen im Bereich von Registermarken erzeugt und deren Abweichungen zur Steuerung des Laserbearbeitungssystems genutzt werden (Positionsabweichungen).

Die Erfindung betrifft auch eine zur Durchführung des Verfahrens konfigurierte Anlage und ein mit Hilfe des Verfahrens hergestelltes oder herstellbares Mehrschichtelement.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können. Ausführungsbeispiele der Erfindung sind in den Zeichnungen dargestellt und werden im Folgenden näher erläutert.

### KURZBESCHREIBUNG DER ZEICHNUNGEN

- Fig. 1: zeigt eine schematische Ansicht einer Ausführungsform einer Anlage zum Herstellen von Mehrschichtelementen mit Laminatstruktur gemäß einer Ausführungsform der Erfindung sowie zwei zugehörige Detaildarstellungen;
- Fig. 2: zeigt eine schematische Draufsicht auf einen Ausschnitt eines bandförmigen Substrats mit einer darauf aufgeklebten Leiterstruktur aus Leiterbahnen einer RFID-Antenne, wobei in lateral ausgedehnten zweiten Bereichen innerhalb und neben der Leiterstruktur punktförmige Haftzonen einer lateral strukturierten Kleberschicht angeordnet sind,
- Fig. 3: zeigt eine ähnliche Darstellung wie Fig. 2 mit einem gleichmäßigen Klebermuster mit punktförmigen Haftzonen;
- Fig. 4: zeigt eine entsprechende Darstellung mit einer lateral strukturierten Kleberschicht, die ein Rechteckmuster mit sich überkreuzenden linienförmigen Haftzonen aufweist;
- Fig. 5: zeigt eine andere Variante eines rechteckförmigen Klebermusters mit linienhaften Haftzonen in anderer Orientierung;
- Fig. 6: zeigt eine Ausführungsform mit einer vollflächig aufgebrachten Kleberschicht, auf die ein Muster quadratischer Bereiche aus Lack, Farbe oder Tinte aufgetragen wurde, um nicht-haftende Zwischenbereiche zwischen Haftzonen zu erzeugen;
- Fig. 7: zeigt eine andere Variante mit vollflächigem Kleberauftrag und anschließenden punktförmigem Musterauftrag von Lack, Farbe oder Tinte, um die Klebekraft in Zwischenbereichen lokal zu reduzieren;
- Fig. 8: zeigt eine andere Variante mit einer vollflächig aufgebrachten Kleberschicht, auf die nachfolgend eine lateral strukturierte Schicht aus Lack, Farbe oder Tinte in einem streifenförmigen Kreuzmuster aufgebracht wurde, um die Klebekraft in Zwischenbereichen lokal zu reduzieren;
- Fig. 9: zeigt schematisch verschiedene Herstellungsschritte bei einer Ausführungsform mit strukturiertem Kleberauftrag;
- Fig. 10: zeigt schematisch verschiedene Herstellungsschritte bei einer Ausführungsform mit vollflächigem Kleberauftrag und anschließender lokaler Abdeckung von Zwischenbereichen;
- Fig. 11: zeigt verschiedene Varianten der Laserstrukturierung bei unterschiedlichen Klebstoffauftragsvarianten;
- Fig. 12: zeigt verschiedene Varianten der Laserstrukturierung einer Leitermaterialschicht mit unterschiedlichen Strukturierungstiefen;
- Fig. 13: zeigt einen Ausschnitt einer Ausführungsform einer Reinigungseinrichtung zum Entfernen von Folienstücken eines strukturierten Laminats mit einer Saug/Druck-Reinigungswalze in zwei unterschiedlichen Ansichten;
- Fig. 14: zeigt einen Ausschnitt einer anderen Ausführungsform einer Reinigungseinrichtung zum Entfernen von Folienstücken eines strukturierten Laminats mit einer Saug/Druck-Reinigungswalze in zwei unterschiedlichen Ansichten;
- Fig. 15: zeigt eine andere Variante einer Reinigungswalze, die Folienstücke in einem Ansaugabschnitt vom Laminat ablösen, in einen Freigabeabschnitt transportieren und dort mittels Überdruck.wieder freigeben kann; und
- Fig. 16: zeigt eine 3D-Darstellung des Oberflächenprofils einer Kleberschicht, die in einem lateral ausgedehnten zweiten Bereich liegt und mittels Laserstrahlung zur Erzeugung punktförmiger Haftzonen strukturiert wurde.

### DETAILLIERTE BESCHREIBUNG BEVORZUGTER AUSFÜHRUNGSBEISPIELE

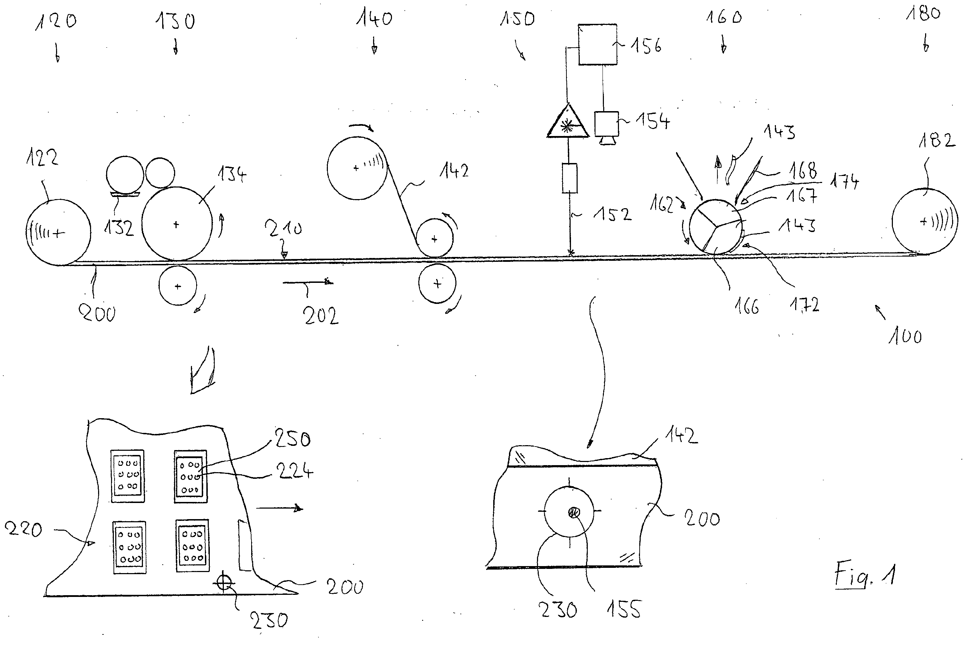

In Fig. 1 ist eine Ausführungsform einer Anlage 100 zum Herstellen von laminierten Mehrschichtelementen auf flexiblen bandförmigen Substraten in einem Rolle-zu-Rolle-Verfahren gezeigt. Die beispielhaft dargestellte Anlage ist für die Herstellung von Antennen für Radiofrequenz-Identifikationssysteme (RFID-Antennen) konfiguriert, kann jedoch auch zur Herstellung anderer mittels Laminierung herstellbarer Mehrschichtelemente mit leitfähigen Strukturen, z.B. für elektrische Schaltungen, verwendet werden. Beispielsweise können bei entsprechender Konfiguration auch mehrseitige Leiterplatten, Kondensatoren, Elektroden von gedruckten Batterien, Sensoren, z.B. Dehnmessstreifen, oder Aktoren hergestellt werden.

Die modular aufgebaute Anlage verarbeitet im Beispielsfall in einer linearen Fertigungslinie ein flexibles Substrat 200, das in Form eines langen flachen Bandes vorliegt und beispielsweise durch eine Kunststofffolie oder eine Papierbahn gebildet sein kann. In speziellen Anwendungsfällen sind auch andere Nichtleiter oder Folien aus Metall oder mit Metallschichten als Substrat verwendbar. Das frische, noch unbearbeitete Substratmaterial wird von einer Vorratsrolle 122 abgezogen, welche sich in einer Abwickeleinrichtung 120 an der Eingangsseite der Anlage befindet. Von dort wird das Substrat durch verschiedene Einrichtungen bzw. Module der Anlage hindurch in Transportrichtung 202 kontinuierlich bis zu einer Aufwickelrolle 182 gefördert, die sich in einer Aufwickeleinrichtung 180 am Ende der Anlage 100 befindet. Während des Transports eines Abschnitts des Substrats durch die Anlage durchläuft der Abschnitt nacheinander unterschiedliche Arbeitsstationen der modular aufgebauten Anlage, die jeweils zur Durchführung eines oder mehrerer Arbeitsschritte des Herstellungsverfahrens konfiguriert sind.

Eine Kleberauftrageinrichtung 130 ist dafür konfiguriert, auf der Oberseite 210 des durchlaufenden Substrats über eine vorgegebene Arbeitsbreite, die in der Regel kleiner ist als die Bandbreite des Substrats, eine dünne Kleberschicht aufzubringen. In einer nachgeschalteten Laminiereinrichtung 140 wird ein Leiterfolie 142, beispielsweise eine Aluminiumfolie oder eine andere Metallfolie, auf die Kleberschicht unter Druck aufgebracht, so dass die Leiterfolie mit dem Substrat durch die zwischenliegende Kleberschicht verbunden wird, wodurch ein Laminat entsteht. In einer nachgeschalteten Laserbearbeitungseinrichtung 150 wird die auflaminierte Metallfolie lateral strukturiert, indem die Leiterfolie an den Grenzen derjenigen Bereiche, die die gewünschte Leiterstruktur der fertigen RFID-Antenne bilden sollen, mittels eines Laserstrahl durchtrennt wird. Dabei entstehen je nach Layout der Leiterstruktur mehr oder wenige große Folienstücke der Metallfolie, die nicht zum gewünschten Endprodukt gehören und deshalb entfernt werden müssen.

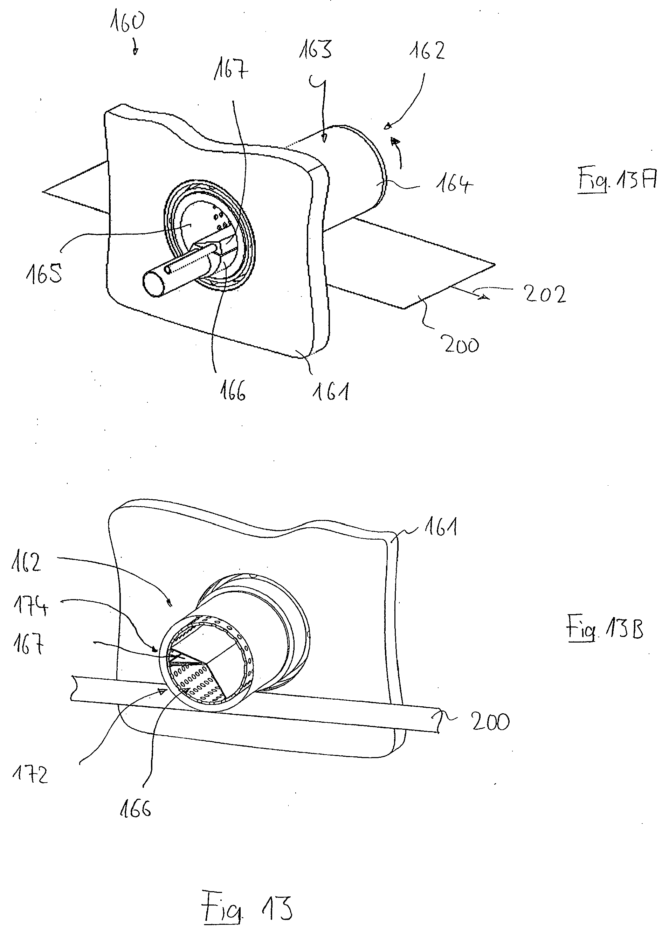

Zum Reinigen, d.h. zum Entfernen der Folienstücke, ist eine nachgeschaltete Reinigungseinrichtung 160 vorgesehen, die im Beispielsfall eine mittels Unterdruck und Überdruck arbeitende Reinigungswalze 162 aufweist (vgl. Ausführungsformen in den Fig. 13 bis 20). Die Reinigungswalze hat eine gasdurchlässige Außenwalze und einen Walzenkern mit einer Unterdruckkammer 166 und einer Überdruckkammer 167, um in einem Ansaugabschnitt 172 Folienstücke durch Unterdruck anzusaugen, in einen Freigabeabschnitt 174 zu fördern und dort mittels Überdruck freizugeben. Die freigegebenen Folienstücke werden mittels einer Absaugeinrichtung 168 mittels eines Luftstroms weggefördert.

Fig. 1 zeigt nur wenige Einrichtungen der Gesamtanlage. Diese kann bei der gezeigten und anderen Konfigurationen weitere Einrichtungen bzw. Module aufweisen. Beispielsweise kann zwischen der Abwickeleinrichtung 120 und der Kleberauftrageinrichtung 130 noch eine Vorreinigungseinrichtung zur Reinigung des Substrats unmittelbar vor dem Kleberauftrag vorgesehen sein. Zwischen der Kleberauftrageinrichtung und der Laminiereinrichtung können noch ein oder mehrere Klebernachbehandlungseinrichtungen vorgesehen sein. Beispielsweise kann eine Trocknungseinrichtung vorgesehen sein, um einen nach dem Kleberauftrag noch zu feuchten Kleber vor der Laminierung zu trocknen. Bei Verwendung von Klebern, die erst durch eine Nachbehandlung aktiviert werden, kann eine entsprechende Aktivierungseinheit vorgesehen sein. Bei Verwendung eines durch Ultraviolettstrahlung aktivierbaren Klebers kann beispielsweise eine UV-Strahlungseinheit vorgesehen sein. Wenn Kleber zunächst vollflächig aufgetragen wird, kann zwischen der Kleberauftrageinrichtung und der Laminiereinrichtung eine Nachbehandlungseinrichtung angeordnet sein, die z.B. ein Flexodruckwerk oder ein Strahldruckwerk zum Auftragen einer lateral strukturierten Abdeckschicht zur Erzeugung von Zwischenbereichen zwischen Haftzonen aufweisen kann. Nach der Abreinigung der fertig strukturierten Substratbahn können die fertig gestellten Mehrschichtelemente mittels einer Schneideinrichtung vereinzelt werden, welche zwischen der Reinigungseinrichtung 160 und der Aufwickeleinrichtung 180 angeordnet sein kann.

Die Kleberauftrageinrichtung 130 ist so konfiguriert, dass eine lateral strukturierte Kleberschicht mit beschichteten Bereichen und unbeschichteten Bereichen auf die Oberseite 210 des Substrats aufgebracht werden kann. Hierzu hat die Kleberauftrageinrichtung ein für den Flexodruck eingerichtetes Druckwerk, bei dem Kleberflüssigkeit von einem Klebervorrat 132 über ein Walzenwerk auf einen Druckformzylinder 134 übertragen wird, der eine flexible Druckplatte mit erhabenen Strukturen trägt, die den Kleber auf die Substratoberseite übertragen.

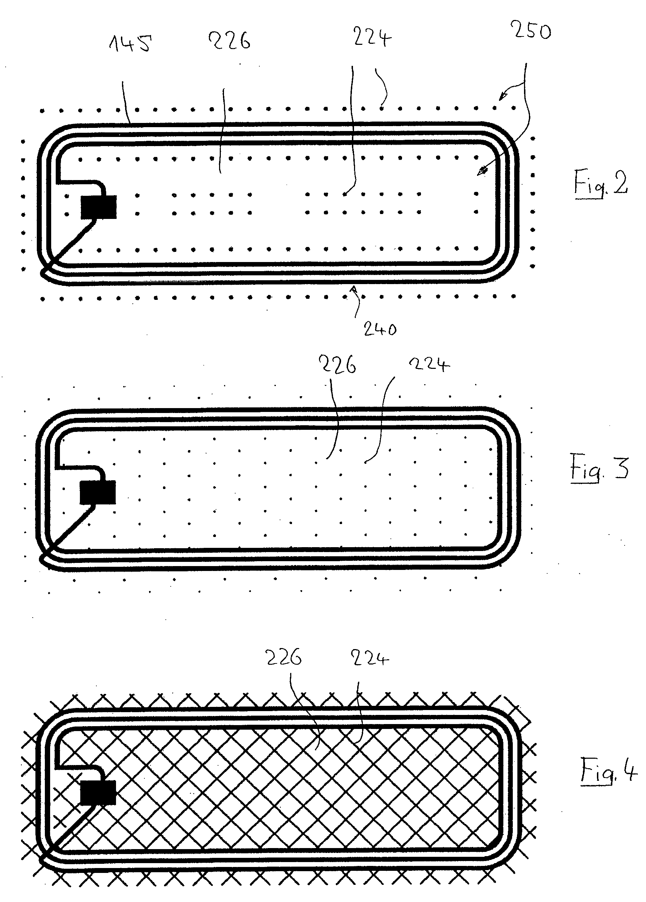

In der darunter dargestellten Detailfigur ist eine Draufsicht auf einen Ausschnitt des durchlaufenden Substrats 200 gezeigt. Im Beispielsfall bildet die lateral strukturierte Kleberschicht 220 für jede später herzustellende RFID-Antenne einen äußeren rechteckförmigen Ring, dessen Breite so bemessen ist, dass die Leiterbahnen der aufzubringenden Leiterstruktur vollflächig auf diesem Ring liegen können (vgl. z.B. Fig. 2). Im Inneren des Rings befindet sich ein im Wesentlichen rechteckförmiger lateral ausgedehnter zweiter Bereich 250, der im fertigen Produkt kein Leitermaterial aufweisen soll. In diesem lateral ausgedehnten zweiten Bereich wird punktuell Kleber aufgebracht, um ein gerastertes Muster relativ kleiner Haftzonen 224 zu bilden. Auch lateral ausgedehnte zweite Bereiche außerhalb des rechteckförmigen Kleberrings können punktuell verteilte können Kleberstellen aufweisen. Insbesondere kann der Bereich zwischen den Ringen teilweise (zumindest in der Nähe der Ringe) oder vollständig mit kleinen Haftzonen bedeckt sein.

Bei der gleichen Druckoperation wird am Rande der Substratbahn neben demjenigen Bereich, auf den später die Metallfolie laminiert wird, ein klebender Anteil einer Registermarke 230 aufgetragen, deren Position relativ zu den Bereichen des Kleberauftrags für die RFID-Antennen genau definiert ist, da der Kleberauftrag im gleichen Druckprozess erfolgt. In einer nicht dargestellten Einrichtung zwischen Kleberauftragseinrichtung und Laminierungseinrichtung wird auf diese klebende Registermarke ein Farbpulver gestreut oder auf andere Weise aufgebracht, um einerseits den Kleber zu binden und andererseits die Registermarke für eine spätere Kameraerfassung sichtbar zu machen.

In den Fig. 2 bis 5 sind verschiedene Beispiele für die räumliche Verteilung von Klebermaterial in einer lateral strukturierten Kleberschicht gemeinsam mit der später aufgebrachten und durch Laserstrukturierung erzeugten Leiterstruktur 145 dargestellt. Diejenigen Bereiche, in denen die Leiterstruktur am fertigen Produkt verbleibt, werden hier als erste Bereiche 240 bezeichnet. Diejenigen benachbart zu den ersten Bereichen liegenden Bereiche, die im fertigen Produkt elektrisch nicht leitend sein sollen, werden als zweite Bereiche 250 bezeichnet. Die zweiten Bereiche können nochmals unterteilt werden in relativ schmale zweite Bereiche, die insbesondere zwischen den Leiterbahnen der Leiterstruktur 145 liegen, und lateral ausgedehnte zweite Bereiche, deren Ausdehnung typischerweise vielfach größer ist als die Breite der Leiterbahnen oder die Breite der schmalen, zwischen den Leiterbahnen liegenden Bereiche. Beispielsweise ergibt sich im Inneren der ringförmig geschlossenen Leiterstruktur ein im Wesentlichen rechteckförmiger zweiter Bereich. Außerdem schließen sich an den äußeren Rand der Leiterstruktur zweite Bereiche an, die sich bis zu benachbarten Leiterstrukturen erstrecken können.

Der Kleberauftrag erfolgt bei derartigen Strukturen so, dass unterhalb der Leiterstruktur, d.h. in den ersten Bereichen, der Kleber vollflächig (lückenlos) aufgetragen wird, während in lateral ausgedehnten zweiten Bereichen 250 Kleber nur partiell aufgetragen wird, so dass sich punktförmige Haftzonen 224 ergeben, die beispielsweise im Wesentlichen eine Rechteckraster folgend über die Substratoberfläche verteilt sind. Typischerweise liegt der Flächenanteil der Haftzonen bezogen auf die Gesamtfläche der zweiten Bereiche im Bereich weniger Prozent, beispielsweise zwischen 2% und 50%, insbesondere zwischen 5% und 30%.

Bei einem Herstellungsverfahren kann z.B. ein drucksensitiver Kleber (pressure sensitive adhesive, PSA) verwendet, der nach dem Kleberauftrag durch Druck unter Einstrahlung von UV-Strahlung noch aktiviert wird. Auch die Verwendung thermisch aktivierbarer Kleber ist möglich. Die Dicke der Kleberschicht kann beispielsweise zwischen 20 µm und 100 µm, insbesondere im Bereich zwischen 50 µm und 80 µm liegen. Die Dicke der Leiterfolie ist typischerweise geringer als diejenige der Kleberschicht und kann beispielsweise zwischen 5 µm und 50 µm liegen, insbesondere im Bereich zwischen 10 µm und 20 µm. Im Beispielsfall einer RFID-Antenne kann die Breite der Leitermaterialbahnen beispielsweise zwischen 0,1 mm und 2 mm, insbesondere zwischen 0,5 mm und 1 mm liegen. Der laterale Abstand benachbarter Haftzonen kann in der gleichen Größenordnung liegen, ist jedoch häufig größer als die Leitermaterialbahnbreite.

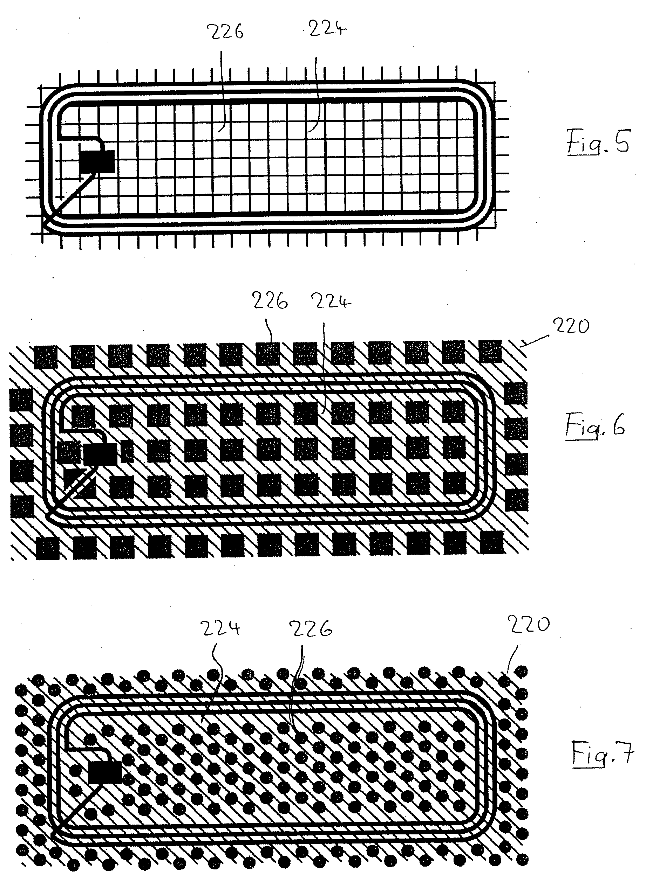

Bei der Ausführungsform von Fig. 3 liegt innerhalb der lateral ausgedehnten zweiten Bereiche eine gleichmäßige Verteilung punktförmiger Haftzonen in einer hexagonalen Symmetrie vor. Die Beispiele der Fig. 4 und 5 zeigen, dass Haftzonen 224 auch als mit Abstand zueinander liegende Linien gestaltet sein können, die sich in den Beispielsfällen jeweils überkreuzen, in anderen Fällen jedoch auch kreuzungsfrei nebeneinander liegen können. Auch hier liegen jeweils senkrecht zu den Linienverläufen der Haftzonen laterale Abstände zu den benachbarten Haftzonen vor, so dass sich im Vergleich zu den Haftzonen relativ große quadratische rechteckförmige Zwischenbereiche 226 ohne Haftkraft bilden.

Eine alternative Vorgehensweise zur Erzeugung einer Kleberschicht, die in lateral ausgedehnten zweiten Bereichen nach einem bestimmten Muster verteilte Haftzonen und zwischenliegende Zwischenbereiche ohne oder mit nur reduzierter Haftkraft aufweisen, wird anhand der Fig. 6 bis 8 näher erläutert. Bei dieser Verfahrensvariante wird zunächst eine Kleberschicht gleichmäßiger Schichtdicke vollflächig, d.h. in den ersten und den zweiten Bereichen auf das Substrat aufgetragen. Dies kann z.B. mittels einer glatten Druckwalze oder mittels Aufsprühen, Slot-Dye-Casting oder dergleichen durchgeführt werden. Um danach innerhalb der lateral ausgedehnten Bereiche eine Verteilung von Haftzonen mit relativ geringem Flächenanteil und dazwischen liegenden Zwischenbereichen im Wesentlichen ohne Haftkraft zu erhalten, werden danach diejenigen Zwischenbereiche, die verminderte oder keine Haftkraft haben sollen, nachbearbeitet. Eine Nachbearbeitung kann insbesondere durch eine oder mehrere der folgenden Maßnahmen erreicht werden: Strukturierung mit elektromagnetischer Strahlung, z.B. Laserstrahlung; mechanische Strukturierung, z.B. mittels Stanzen, Abschleifen oder dergleichen; Abdecken mittels einer Abdeckschicht, beispielsweise mittels UV-Lack, Tinte oder Farbe; Aktivieren von Kleberbereichen durch elektromagnetische Bestrahlung wie z.B. durch UV-Licht oder chemisch durch Hinzugabe/Einbringung eines Stoffes. Inaktivierung von Kleberbereichen durch elektromagnetische Strahlung wie z.B. UV-Strahlung oder Laserstrahlung zum Aushärten des Klebermaterials. Eine Inaktivierung kann auch chemisch durch Hinzugabe/Auftrag eines geeigneten Stoffes zwischen dem Substrat und der Leiterfolie erfolgen.

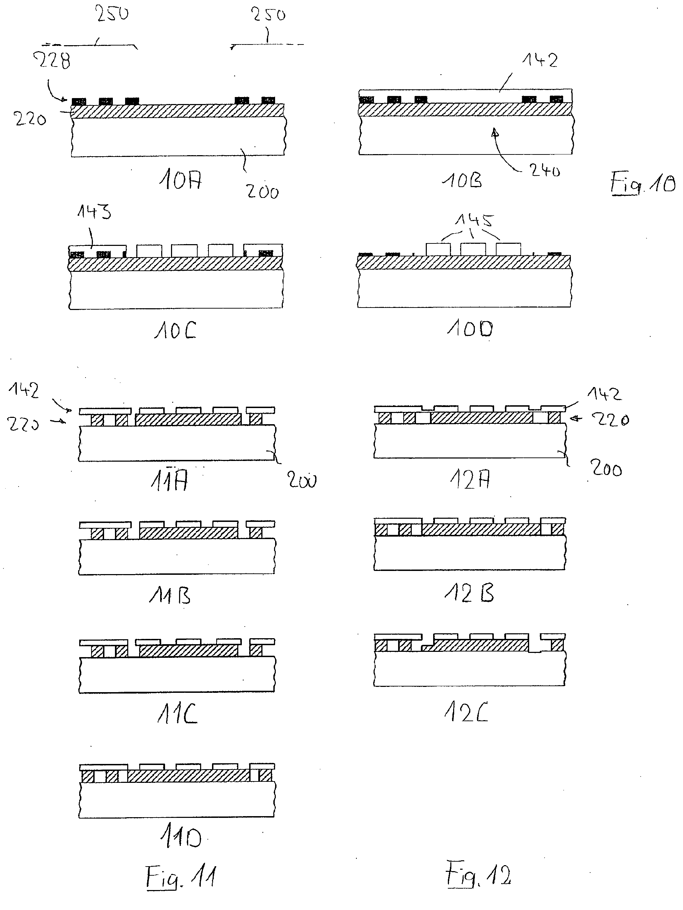

Bei den Beispielen der Fig. 6 bis 8 wurde zur Erzeugung der nichthaftenden Zwischenbereiche 226 eine dünne Abdeckschicht 228 (vgl. Fig. 10) einer druckfähigen Substanz gemäß einem entsprechenden Muster so aufgetragen, dass die Substanz die Kleberschicht lokal abdeckt und dadurch die Klebekraft in den Zwischenbereichen lokal reduziert. Hierzu kann beispielsweise ein Lack, eine Farbe oder eine Tinte verwendet werden. Die Substanz kann analog zum oben beschriebenen Kleberauftrag z.B. im Flexodruckverfahren oder mittels eines Ink-Jet-Verfahrens aufgebracht werden kann.

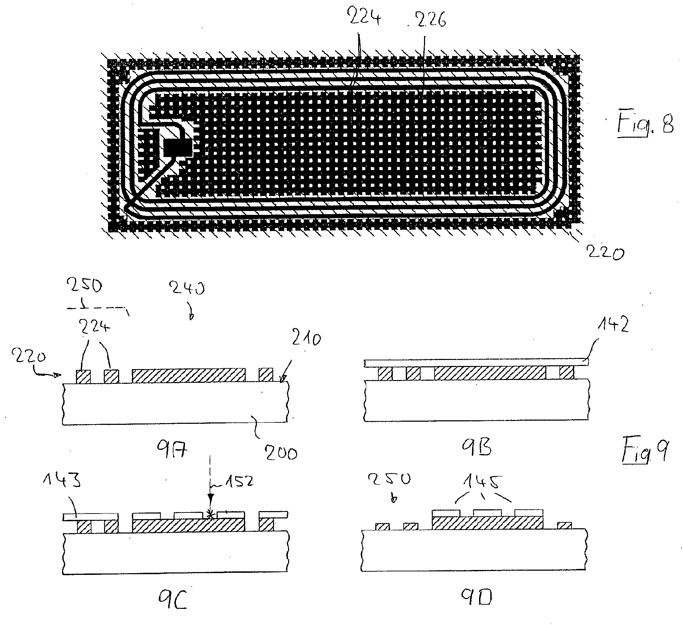

Im Hinblick auf die räumliche Verteilung von klebenden Haftzonen und nicht oder nur schwach klebenden Zwischenbereichen über die Substratoberfläche sei noch Folgendes angemerkt. Bei den Beispielen der Fig. 2, 3 und 8 ergeben sich jeweils punktförmige Haftzonen 224, die in alle Richtungen von kleberfreien, nicht-klebenden Zwischenbereichen 226 umgeben sind. Hier liegt in allen Richtungen innerhalb der beschichteten Fläche ein Abstand zwischen benachbarten Haftzonen vor. Die Haftzonen können im Querschnitt rund oder oval oder gegebenenfalls auch polygonal (Fig. 8) gestaltet sein. Bei den Ausführungsformen der Fig. 4, 5, 6 und 7 ergeben sich Haftzonen, die mehr oder weniger nach Art eines Liniengitters zusammenhängen, wobei sich zwischenliegende Zwischenbereiche ergeben, die allseitig von Haftzonen umgeben sind. Hier liegt in gewissen Richtungen (quer zu den Linien) innerhalb der beschichteten Fläche ein Abstand zwischen benachbarten Haftzonen vor. In jedem Fall kann durch die gewählte Vorgehensweise bei der Strukturierung die räumliche Verteilung der Haftzonen, deren Form und Größe sowie der Flächenanteil der Haftzonen in Bezug auf die Gesamtfläche der lateral ausgedehnten zweiten Bereiche gezielt vorgegeben werden, um in den lateral ausgedehnten zweiten Bereichen insgesamt ein gewünschtes Niveau an Haftkraft einzustellen, die einerseits die freigeschnittenen Folienstücke zunächst zuverlässig in den zweiten Bereichen hält und später bei der Ablösung ein sicheres Ablösen zulässt.

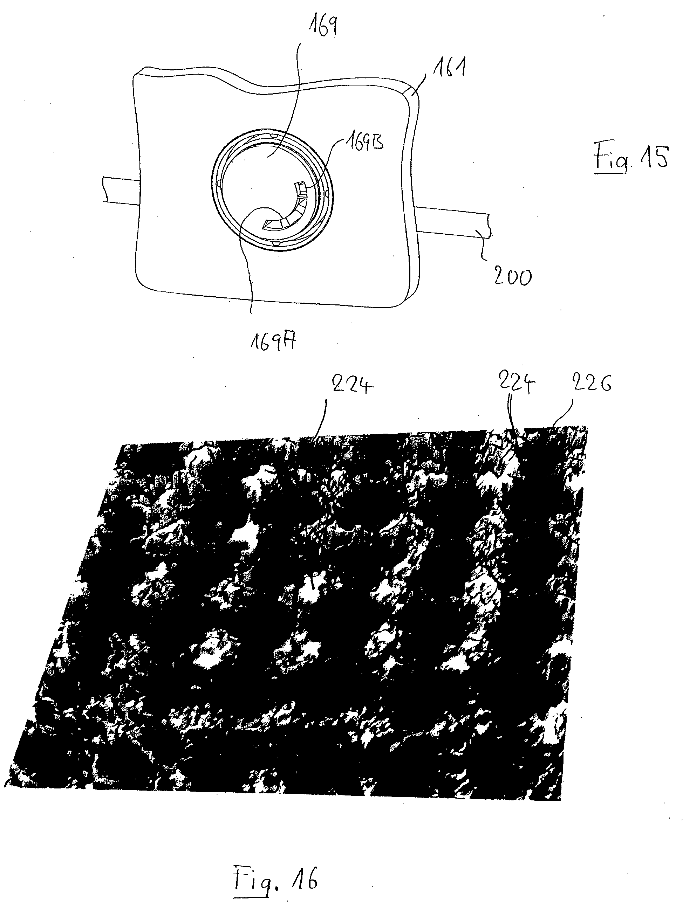

Anhand von Fig. 16 ist eine weitere Möglichkeit zur Herstellung einer lateral strukturierten Kleberschicht gezeigt. Die Figur zeigt eine schrägperspektivische 3D-Darstellung des Oberflächenprofils einer Kleberschicht, die in einem lateral ausgedehnten zweiten Bereich liegt und mittels Laserstrahlung zur Erzeugung punktförmiger Haftzonen strukturiert wurde. Dazu wurde in einer ursprünglichen Kleberschicht gleichmäßiger Schichtdicke Laserlicht in einem Rechteckraster so eingestrahlt, dass nach oben hervorstehende Haftzonen 224 (helle Bereiche) bleiben, in deren Bereich die Schichtdicke im Wesentlichen der ursprünglichen Schichtdicke entspricht. In den dunkel erscheinenden Zwischenbereichen 226 wurde durch die Einwirkung der Laserstrahlung das Klebermaterial teilweise abgetragen und/oder so umgewandelt, dass dort praktisch keine Klebekraft mehr verbleibt.

Nachdem eine elektrisch leitfähige Schicht (Leiterschicht) in Form einer Metallfolie mittels der direkt oder nachfolgend lateral strukturierten Kleberschicht in einer Laminierungsoperation am Substrat befestigt wurde, wird die Leiterfolie zur Erreichung der gewünschten Zielkontur, nämlich der angestrebten Leiterstruktur, strukturiert. Für die Bearbeitung der Kontur eignet sich bevorzugt elektromagnetische Strahlung wie Laserstrahlung, die mittels Scanner oder in einem Maskenprojektionsverfahren und gegebenenfalls mit Strahlteilung für Parallelverarbeitung eingesetzt werden kann. In der beispielhaften Anlage ist eine Laserbearbeitungseinrichtung 150 vorgesehen, die als Laserscanner konfiguriert ist und einen fokussierten Laserstrahl 152 erzeugt, der als Trennwerkzeug dient und mittels einer Scaneinrichtung entlang der Grenzen der zu erzeugenden Leiterstruktur entlang geführt wird. Typische Schnittbreiten bei fokussiertem Laserstrahl können z.B. im Bereich zwischen 1 µm und 250 µm liegen, insbesondere zwischen 30 µm und 120 µm.

Das Laserbearbeitungssystem der Anlage 100 umfasst (mindestens) eine Kamera 154, die an die Steuereinrichtung 156 des Lasersystems angeschlossen ist und mit ihrem Bildfeld den Randbereich der durchlaufenden Substratbahn erfassen kann, in welchem sich die Registermarke 230 befindet (siehe Detail unterhalb Laserbearbeitungseinrichtung). Das Laserbearbeitungssystem ist so programmiert, dass automatisch in gewissen Zeitabständen oder kontinuierlich eine Selbstkalibrierung durchgeführt wird, wodurch höchste Positioniergenauigkeit bei der Laserbearbeitung am bewegten Substrat erreicht werden kann. Hierfür wird zu einem vorgegebenen Zeitpunkt im Bereich der am Rand des Substrats angebrachten Registermarke 230 eine Lasermarkierung 155 erzeugt, indem der Laserstrahl kurzzeitig auf die Registermarke gerichtet wird. Die Kamera 154 erfasst den Bereich der Registermarke und leitet die Bilddaten zur Steuereinrichtung 156, die ein Bildverarbeitungssystem umfasst, um aus den Bilddaten eine gegebenenfalls vorhandene Abweichung der Lage der Lasermarkierung 155 von der erwarteten Soll-Lage im Zentrum der Registermarke 230 zu bestimmen. Hieraus werden ein und mehrere Abweichungsparameter abgeleitet, die von der Steuerung 156 verarbeitet werden können, um Korrekturwerte für die Laserbearbeitung zu errechnen und Komponenten des Laserbearbeitungssystems (beispielsweise Linsen, Spiegel oder dergleichen) so zu verändern, dass die Abweichung minimiert wird. Auf diese Weise können beispielsweise Drifteffekte vermieden werden und es ist auch bewegtem Substrat möglich, den Laserstrahl genau entlang der gewünschten Schnittlinie zu führen.

Bei diesem Verfahrensschritt können vorhandene Registermarken und die in deren Bereich zur erzeugenden Lasermarkierungen jeweils eine kreisförmige oder runde oder andersartig geschlossene Form aufweisen und ineinander liegen, so dass bei einer eventuellen Dezentrierung der Abweichungsparameter abgeleitet werden kann. Es sind jedoch auch andere Formen möglich. Die Registermarken und die Lasermarkierungen müssen auch nicht ineinander liegen, sondern können nebeneinander vorliegen. Günstig ist es, wenn sowohl die Registermarkierung als auch die in deren Bereich eingebrachte Lasermarkierung mit dem gleichen Erfassungssystem, beispielsweise einer Kamera, zeitgleich erfasst werden können.

Fig. 9 zeigt in den Teilfiguren 9A bis 9D verschiedene Phasen der Herstellung eines strukturierten Laminats bei derjenigen Verfahrensvariante, bei der direkt ein strukturierter Kleberauftrag erfolgt. Zunächst wird die lateral strukturierte Kleberschicht 220 auf die Oberfläche 210 des Substrats 200 aufgebracht, wobei in den ersten Bereichen 240 vollflächig aufgetragen wird und in lateral ausgedehnten zweiten Bereichen 250 kleine Haftzonen 224 mit lateralem Abstand zueinander erzeugt werden. In der Laminierungsoperation (Fig. 9B) wird die Metallfolie 142 auf der klebenden Oberfläche der strukturierten Kleberschicht fixiert. Bei der Strukturierungsoperation in der Laserbearbeitungseinrichtung wird die Materialfolie entlang der Grenzen der gewünschten Leiterstruktur vollständig durchtrennt. Innerhalb der lateral ausgedehnten Bereiche bleiben größere zusammenhängende Folienstücke 143 an den räumlich verteilten Haftzonen haften, so dass der strukturierende Schritt nicht durch sich eventuell ablösende größere Folienstücke gestört wird. In den schmalen Zwischenbereichen zwischen den gewünschten Leiterbahnen wird die Materialfolie ebenfalls mittels Laserablation abgetragen, wobei im Beispielsfall die Kleberschicht darunter vollflächig erhalten bleibt. Bei der nachfolgenden Abreinigung in der Reinigungseinrichtung werden die zusammenhängenden größeren Folienstücke 143 entfernt. Am fertigen Endprodukt (Fig. 9D) ist die gewünschte Leiterstruktur durch den vollflächigen Haftkontakt in den ersten Bereichen fest mit dem Substrat verbunden. In den lateral ausgedehnten, elektrisch nicht leitenden zweiten Bereichen 250 verbleibt in der Regel ein strukturiertes Muster von Klebermaterial, welches das Substrat in diesen freiliegenden Bereichen mechanisch stabilisiert.

Fig. 10 stellt Herstellungsschritte für Verfahrensvarianten mit vollflächigem Kleberauftrag und nachträglicher lokaler Abdeckung von Zwischenbereichen zwischen Haftzonen schematisch dar. Nach dem vollflächigen Kleberauftrag einer gleichmäßig dicken Kleberschicht 220 wird eine strukturierte Lackschicht 228 nach einem vorgegebenen Muster aufgetragen, wobei die ersten Bereiche, die am fertigen Produkt die Leitermaterialschicht tragen, nicht abgedeckt werden. Die Dicke der Abdeckschicht ist zu Illustrationszwecken stark überhöht dargestellt. Sie beträgt in der Regel nur einen Bruchteil der Kleberschichtdicke. Danach wird die Metallfolie auf der teilweise abgedeckten Kleberschicht fixiert (Fig. 10B), wodurch ein Laminat entsteht, bei dem in den ersten Bereichen 240 starker Haftkontakt zwischen Kleber und Folie besteht, während in den lateral ausgedehnten zweiten Bereichen 250 nur punktuelle oder linienhafte Haftkontakte in den Haftzonen zwischen den Zwischenbereichen besteht. Danach wird die leitfähige Schicht (Metallfolie) mittels Laser (oder auf andere Weise) strukturiert (Fig. 10C), wobei in lateral ausgedehnten zweiten Bereichen größere Folienstücke 143 am Substrat zunächst haften bleiben. Die zu entfernenden Bereiche der leitfähigen Schicht, d.h. die Folienstücke, werden dann später in der Reinigungsoperation entfernt (Fig. 10D).

In Fig. 11 sind einige Varianten der Laserstrukturierung der unterschiedlichen Klebstoffauftragsvarianten dargestellt. Bei der Variante in Fig. 11 A überragt der Kleber die leitfähige Schicht des ersten Bereiches zumindest an einer Kante leicht. Bei Fig. 11 B ist der Kleber zumindest an einer Kante mit der Leiterstruktur im ersten Bereich bündig. Bei der Variante in Fig. 11C ist nach der Strukturierung die Kleberschicht zumindest an einer Kante nicht ganz bis zur Kante der leitfähigen Struktur vorhanden. Fig. 11D zeigt, dass Klebstoff zumindest im Bereich einer Kante der Leiterstruktur auch bis in den Bereich eines zu entfernenden Folienstücks reichen kann.

Anhand von Fig. 12 wird beispielhaft dargestellt, dass bei der Strukturierung der Leitermaterialschicht, des Klebstoffs sowie des Substrats je nach Bedarf unterschiedliche Strukturierungstiefen erzeugt werden können. Bei Fig. 12A wird nur die leitfähige Schicht bis zu einer gewissen Tiefe strukturiert, ohne sie vollständig zu durchtrennen. Die darunter liegende Kleberschicht wird dabei nicht erreicht. Gemäß Fig. 12B wird die Leiterfolie bzw. die leitfähige Schicht bis zur Oberfläche des Klebers strukturiert und dabei vollständig durchtrennt, wobei der Kleber im Wesentlichen unbearbeitet bleibt. Bei der Variante von Fig. 12C wird bis in den Kleber und punktuell sogar bis in die Oberfläche des Substrats hinein strukturiert.

Es sei erwähnt, dass auch beidseitige Schnitte von der Oberseite des Substrats und der Unterseite des Substrats möglich sind, beispielsweise um Durchkontaktierungen von einer Seite zur anderen zu ermöglichen, wenn dies bei mehreren elektronisch funktionellen Schichten auf einer oder beiden Seiten des Substrats notwendig wird.

Alternativ zur Strukturierung mittels elektromagnetischer Strahlung können je nach Materialien und Bauformen auch mechanische Verfahren wie beispielsweise das Stanzen oder eine Wasserstrahlbearbeitung oder chemische Verfahren, wie Ätzen, gegebenenfalls mit Schutzabdeckung für nicht zu entfernende Bereiche oder aber auch ein Lift-off-Verfahren eingesetzt werden, wobei die Varianten gegebenenfalls auch in Kombinationen eingesetzt werden können.

Anhand der Fig. 13 bis 15 werden verschiedene Ausführungsformen von Reinigungseinrichtungen zur Entfernung der Folienstücke nach der Strukturierungsoperation erläutert. Fig. 13 zeigt in 13A eine Seitenansicht und in Fig. 13B eine Innenansicht eines Ausschnitts einer Reinigungseinrichtung 160, bei der in einer vertikalen Seitenwand 161 eine Reinigungswalze 162 mit horizontaler Drehachse derart gelagert ist, dass sich zwischen der Außenfläche 163 der Reinigungswalze und der Oberseite der in Transportrichtung 202 durchlaufenden Substratbahn 200 ein schmaler, praktisch linienförmiger schlupffreier Abrollkontakt ergibt. Es kann ggf. auch ein kleiner vertikaler Abstand, typischerweise in der Größenordnung von 0.1 mm oder darunter, vorliegen Die Drehachse der Walze verläuft senkrecht zur Transportrichtung 202.

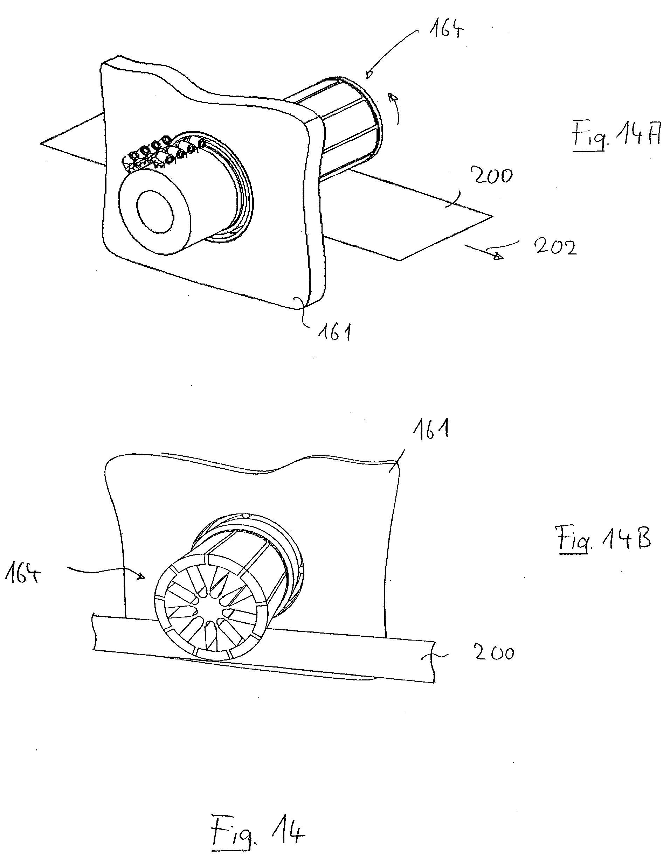

Die Reinigungswalze 162 hat eine in Radialrichtung gasdurchlässige Außenwalze 164, die mittels eines nicht gezeigten Antriebs um ihre horizontale Drehachse mit einstellbarer Drehzahl gedreht werden kann und als bewegbares Förderelement der Reinigungseinrichtung fungiert. Die Außenwalze umschließt einen feststehenden Walzenkern 165. Der Walzenkern umfasst eine Unterdruckkammer 166, die an die Saugseite einer Pumpe angeschlossen ist, und eine in Drehrichtung der Reinigungswalze dahinter angeordnete Überdruckkammer 167, die an die Druckseite einer Pumpe angeschlossen ist. Die Innenansicht in Fig. 14B zeigt, dass im Innern des Walzenkerns die der Substratbahn zugewandte Unterdruckkammer 166 und die nach schräg oben gerichtete Überdruckkammer 167 in Umfangsrichtung durch relativ einfache im Innern des Walzenkerns quer verlaufende plattenförmige Bleche begrenzt sind.

Die Druckkammern sind zur Außenwalze 164 hin offen und gegenüber dieser an den Rändern der Gehäuseteile der Druckkammern abgedichtet. Wie auch in Fig. 1 gezeigt, ergibt sich aufgrund der radialen Gasdurchlässigkeit der Außenwalze im Bereich der Überdruckkammer 166 ein Ansaugabschnitt 172, der sich über ca. 90° bis 120° des Walzenumfangs erstreckt und den Bereich größter Annäherung zwischen der Reinigungswalze und der Substratbahn umfasst. Hier kann die Reinigungswalze auf die an der Substratbahn noch haftenden Folienstücke 143 eine anziehende Wirkung mittels Unterdruck ausüben. Im Bereich der in Drehrichtung nachfolgenden Überdruckkammer 167 ergibt sich dagegen durch den Überdruck in einem schmaleren Freigabeabschnitt 174 eine abstoßende Wirkung zwischen der Außenwalze und den anhaftenden Folienstücken.

Die Außenwalze 164 übt dadurch eine Doppelfunktion aus. Wie in Fig. 1 schematisch dargestellt, sorgt der Ansaugabschnitt dafür, dass die an der Substratbahn im Bereich der Haftzonen noch haftenden Folienstücke von der Substratbahn abgelöst werden, auf die Außenwalze übertragen werden und an der Außenseite der Reinigungswalze haften. Durch die Drehung der Reinigungswalze werden sie am Ansaugabschnitt haftend bis in den Bereich des unter Überdruck stehenden Freigabeabschnitts gefördert. Dort werden die Folienstücke mittels Überdruck von der Außenfläche 163 des hülsenförmigen Förderelements (Außenwalze) aktiv abgestoßen und geraten in den Wirkungsbereich der Absaugrichtung 168, die die Folienstücke kontrolliert nach oben abfördert.

Dieses Reinigungsprinzip kann technisch auf unterschiedliche Weise umgesetzt werden. Beim Ausführungsbeispiel von Fig. 13 besteht die zylindrische Außenwalze aus einem offenporösen Walzenmaterial, beispielsweise ein offenporigen Sinterwerkstoff aus Metall, Keramik oder einem Verbundswerkstoff. Es kann auch ein geschäumter Kunststoff ähnliche eines Schwamms verwendet werden, um eine weiche Antastung des Folienmaterials zu erreichen. Das elastisch nachgiebige poröse Material kann ggf. als Überzug für einen porösen oder auf andere Weise gasdurchlässigen Walzenkörper ausgelegt und ggf. als Verschleißteil auswechselbar sein. Das Material ist bevorzugt vollflächig ausgeführt, so dass sich eine ununterbrochene Außenfläche ergibt. Im Inneren der äußeren Hülse befindet sich ein stabiles hülsenförmiges gasdurchlässiges Sieb, von dem vor allem in Fig. 13B einige radiale Perforationen zu erkennen sind. Die Außenhülse und das Sieb drehen sich gemeinsam.

Bei der Ausführungsform von Fig. 14 ist die hülsenförmige Außenwalze 164 in mehrere in Umfangsrichtung aufeinander folgende Segmente gleicher Umfangsbreite unterteilt. Jedes Segment besteht aus porösem Material, schmale Unterbrechungen zwischen den Segmenten entsprechen den inneren Kammeranordnungen. Im Inneren der Außenhülse, d.h. im Walzenkern, befinden sich separate Druckkanäle bzw. Druckkammern für die einzelnen Segmente, die sich mit der Walze mitdrehen. Die äußeren Druckanschlüsse drehen sich nicht mit. Zwischen den Druckanschlüssen sind im Bereich der Druckleitungen bis an das Innere der Druckkammern abgedichtete Drehdurchführungen angeordnet.

Die Dichtheit an der Stirnseite kann konstruktiv z.B. per Gleitringdichtungen oder Radialdichtungen gewährleistet werden. Innerhalb der Walze kann ausreichende Gasdichtheit z.B. durch geringe Toleranzen, z.B. im Bereich von 0,5 mm oder darunter, zwischen Druckkammer und rotierender Walzeninnenwand erzielt werden. Die Unterbrechungen zwischen den Segmenten sind hinreichend druckdicht, damit kein Gasaustausch zwischen in Umfangsrichtung benachbarten Druckkammern stattfinden kann.

Die Absaugung vom Innern der Druckkammern bzw. das Einblasen von Druckluft erfolgt lagerichtig zur gewünschten Position von Ansaugabschnitt und Freigabeabschnitt. Bei der Ausführungsform von Fig. 15 erfolgt die Druckverteilung nach dem Drehschieber-Prinzip durch eine an der Stirnseite der Druckkammern angebrachte Segmentscheibe 169, die zwei zu den Druckkammern führende, in Umfangsrichtung gekrümmt verlaufende Durchlässe hat. Der breitere Durchlass 169A an der der Substratbahn 200 zugewandten Seite versorgt jeweils drei oder vier benachbarte Druckkammern, ist mit der Saugseite einer Pumpe verbunden und sorgt dafür, dass in den jeweils in den Bereich dieses Schlitzes gelangenden Druckkammern ein Unterdruck vorliegt, um die Folienstücke anzusaugen. Der in Drehrichtung benachbarte kleinere Schlitz 169B versorgt nur jeweils eine oder zwei Druckkammern und ist an die Druckseite einer Pumpe angeschlossen, so dass in diesem Bereich jeweils ein Freigabeabschnitt entsteht, wenn eine in diesem Bereich gedrehte Druckkammer durch den Schlitz hindurch mit Druckluft beaufschlagt wird.

Bei den im Detail beschriebenen Ausführungsbeispielen werden alle Verfahrensschritte des Herstellungsprozesses in einer einzigen modular aufgebauten Anlage in einem Durchlauf durchgeführt. Bei anderen Verfahrensvarianten erfolgt die Laminierung inklusive Kleberauftrag, eventueller Nachbearbeitung und Aufkleben der Leiterfolie in einer separaten Anlage und das als Zwischenprodukt resultierende Laminat wird zunächst aufgerollt und später in einer anderen Anlage, welche dann die Strukturierung und nachfolgende Prozessschritte ausführen kann, von der Rolle weiterverarbeitet.

Anstelle eines Rolle-Zu-Rolle-Verfahrens kann auch ein bogenverarbeitendes Verfahren (Sheet-to-Sheet-Verfahren) genutzt werden.

Es kann bei der Herstellung von Mehrschichtelementen ggf. ein Lift-Off-Verfahren durchgeführt werden. Der Begriff "Lift-off-Verfahren" bezeichnet hierbei ein digitales, laserbasiertes Fertigungsverfahren mit Transferansatz mit folgender Prozessfolge. Als Ausgangsmaterial wird eine Metallfolie und ein Transfersubstrat (beispielsweise eine weitere Folie) verwendet. Die Metallfolie oder das Substrat wird mit einem dünnen Flüssigkeitsfilm beschichtet. Anschließend werden die Metallfolie und das Substrat in einer Laminierungsoperation flächig verbunden, wobei die Haftung auf Adhäsionskräften basiert, die über den dünnen Flüssigkeitsfilm vermittelt werden. Nachfolgend erfolgt eine Erzeugung der gewünschten Zielkontur, d.h. der gewünschten Leiterstruktur, durch selektive Strukturierung der Metallfolie mittels Laser. Bei der Strukturierung wird mit hoher Energieintensität gearbeitet, um eine Ablation des metallischen Folienmaterials zu erzielen. In einer nachfolgenden Lift-off-Operation wird selektiv in die später abzureinigenden Bereiche mittels Laser Energie mit dem Ziel eingestrahlt, das Fluid zwischen dem Substrat und der Metallfolie zu verdampfen. Bei diesem Verfahrensschritt wird mit geringerer Energieintensität gearbeitet als bei der selektiven Strukturierung, so dass die Metallfolie nicht geschädigt wird, das Fluid aber verdampft. Die Bestrahlung kann dabei von der Oberseite und/oder von der Unterseite des Mehrschichtelements erfolgen. Die Energieeinkopplung kann dabei in das Transfersubstrat, das Fluid oder die Metallfolie oder in mehrere dieser Bestandteile der Schichtstruktur erfolgen. Falls erforderlich, kann sich eine zusätzliche Reinigung anschließen. Schließlich erfolgt eine Laminierung zur Erzeugung des Endverbundes. Dabei wird die auf dem Transfersubstrat befindliche strukturierte Folie, d.h. die Leiterstruktur, mit einem weiteren Substrat (Endsubstrat) mittels einer zwischenliegenden Kleberschicht verbunden. Der Kleber kann dabei flächig auf das Substrat und/oder auf die Leiterfolie aufgebracht sein, abhängig vom Zielprodukt kann der Kleber aber auch nur selektiv aufgebracht sein. Falls gewünscht oder erforderlich, kann die bei der Laserstrukturierung verwendete Transferfolie nach dem Laminiervorgang wieder abgezogen werden, so dass die Transferfolie nicht am Endprodukt verbleibt. Hierdurch sind ggf. sehr exakt dimensionierte Leiterstrukturen herstellbar.

Grundsätzlich besteht im Rahmen des Verfahrens und der Anlage die Möglichkeit, nicht nur eine einzige leitfähige Struktur, d.h. eine Leiterstruktur, zu erzeugen, sondern gegebenenfalls mehrere übereinander oder auf der Vorderseite und der Rückseite des Substrats. Gegebenenfalls können Durchkontaktierungen zwischen verschiedenen Schichten durch das Substrat erzeugt werden. Alternativ oder zusätzlich können elektrisch leitende Kontakte über den äußeren Rand eines Bauteils realisiert werden. Wenn an einem leitfähigen Bauteil mehrere in unterschiedlichen Schichten vorliegende Leiterstrukturen erzeugt werden sollen, kann dies dadurch erfolgen, dass nach Abschluss der Herstellung einer ersten Leiterstruktur der Herstellungsprozess nach der Strukturierung der elektrisch leitfähigen Struktur oder nach der Reinigung erneut nach dem Schritt der Bereitstellung des Substrats bzw. des Trägersubstrats beginnt.

Dabei können Schichten auch teilweise oder komplett aus elektrisch nicht leitendem Isoliermaterial oder aus Halbleitermaterialien aufgebaut sein, um komplexere, insbesondere auch mehrschichtige elektrische Bauteile oder sogar integrierte Schaltungen bzw. Schaltkreise herstellen zu können. Außerdem können nach dem Verfahren und/oder mit der Anlage hergestellte Mehrschichtelemente mit weiteren elektronischen Bauteilen, wie z.B. integrierten Schaltungen, Computerchips oder Prozessoren bestückt werden.

Optional kann das Herstellungsverfahren mit Schritten der Qualitätskontrolle während oder nach verschiedenen Bearbeitungsschritten ergänzt werden. Außerdem können auf die nach diesem Herstellungsverfahren erzeugten Produkte mittels einer Druckeinheit, z.B. einer Strahldruckeinheit (ink-jet) oder eines Laserbeschrifters Identifikationsnummern und andere Markierungen auf- oder eingebracht werden. Es ist auch möglich, an einer Seite oder an beiden Seiten des Produkts noch eine Schutzschicht aufzubringen, beispielsweise um eine Einlaminierung in eine Schutzhülle zu erreichen.

Bei einer Verfahrensvariante werden in gewünschter Kontur, d.h. mit gewünschter örtlicher Verteilung, Metallpartikel, nanoskalige oder mikroskalige Metalltinten, Precursortinten, oxidierte Tinten, bevorzugt Metalloxidpartikel in Tinte gelöst oder ähnliche Substanzen auf das Substrat aufgebracht. Die Auftragung kann beispielsweise im Strahldruckverfahren (ink-jet) oder durch Flexodruck erfolgen. Die zunächst in suspendierter Form aufgebrachten Partikel werden anschließend innerhalb der gewünschten Struktur mittels Laserstrahlung oder einer Blitzlampe oder auf andere Weise durch Energieeintrag gesintert und bilden dadurch einen elektrisch leitfähigen Verbund, der stark am Substrat haftet oder mit diesem verschweißt ist. Soll dagegen gezielt ein elektrisch nicht leitfähiger Bereich gefertigt werden, z.B. um elektrische Verbindungen zwischen benachbarten leitfähigen Schichten zu vermeiden, so kann auch eine Tinte oder dergleichen mit nicht-leitfähigen Partikeln anstelle der Metallpartikel verwendet werden. Diese Verfahrensvariante zur Erzeugung von Leiterstrukturen mit gegebenenfalls komplexer Form umfasst somit eine Kombination einer Drucktechnik (zum Auftrag der zu sinternden Partikel) und einen anschließenden Sintervorgang zur Bildung eines Festkörpers aus den Vorstufen.

Diese Verfahrensvariante kann auch in Kombination mit anderen Verfahrensalternativen als Ergänzung sinnvoll sein. Beispielsweise ist es möglich, eine Precursortinte zu drucken und anschließend mittels Laser zu strukturieren, um feinere Details zu generieren, als sie durch Sintern ohne Nachbearbeitung erzielbar wären. Die Sinteroperation kann vor oder nach der Laserstrukturierung durchgeführt werden. Es können auch Brücken oder Durchkontaktierungen gedruckt werden.

## Patentansprüche

1. Verfahren zum Herstellen eines Mehrschichtelements mit einem Substrat und mindestens einer mit dem Substrat flächig verbundenen Leiterstruktur, die erste Bereiche aus elektrisch leitenden Material aufweist, welches nach einem vorgegebenen Muster vorliegt, wobei zwischen den ersten Bereichen elektrisch nicht leitende zweite Bereiche liegen, wobei eine Leiterfolie (142) in den ersten Bereichen fest mit dem Substrat verbunden wird, insbesondere zum Herstellen von RFID-Antennen in einem Rolle-zu-Rolle-Verfahren, **gekennzeichnet durch** die folgenden Schritte:
Verbinden der Leiterfolie (142) mit dem Substrat (200) derart, dass in lateral ausgedehnten zweiten Bereichen ein partieller Haftkontakt zwischen dem Substrat und der Leiterfolie an einer Vielzahl von Haftzonen (224) erzeugt wird;
Strukturieren der Leiterfolie **durch** Schneiden der Leiterfolie entlang von Grenzen der ersten Bereiche; und
Entfernen zusammenhängender Folienstücke (143) der Leiterfolie aus lateral ausgedehnten zweiten Bereichen (250) unter Auflösen des partiellen Haftkontakts zwischen dem Substrat und der Leiterfolie.

2. Verfahren nach Anspruch 1, worin die Leiterfolie (142) mit dem Substrat (200) mittels einer zwischenliegenden Kleberschicht (220) verbunden wird.

3. Verfahren nach Anspruch 2, worin die Kleberschicht (220) derart erzeugt wird, dass die Haftzonen (224) in lateral ausgedehnten zweiten Bereichen (250) ein Punktemuster oder ein Linienmuster bilden und/oder derart, dass ein Flächenanteil der Haftzonen (224) innerhalb der lateral ausgedehnten zweiten Bereiche zwischen 2% und 80%, insbesondere zwischen ca. 5% und ca. 50% liegt, oder worin vor dem Verbinden der Leiterfolie mit dem Substrat eine lateral strukturierte Kleberschicht auf das Substrat oder die Leiterfolie aufgetragen wird, wobei Klebermaterial in den ersten Bereichen (240) vollflächig und in lateral ausgedehnten zweiten Bereichen (250) zur Erzeugung der Haftzonen (224) partiell nach einem vorgegebenen Muster aufgetragen wird, vorzugsweise mittels eines Strahldruckverfahren oder durch ein Flexodruckverfahren.

4. Verfahren nach Anspruch 2, worin vor dem Verbinden der Leiterfolie mit dem Substrat in einer ersten Teiloperation eine Kleberschicht vollflächig in ersten und zweiten Bereichen auf das Substrat oder die Leiterfolie aufgetragen wird und danach in einer zweiten Teiloperation innerhalb der lateral ausgedehnten zweiten Bereiche (250) zwischen den vorgesehenen Haftzonen (224) durch eine Nachbehandlung Zwischenbereiche (226) der Kleberschicht mit verminderter Haftkraft oder ohne Haftkraft dadurch erzeugt werden, wobei vorzugsweise bei der Nachbehandlung in den Zwischenbereichen zwischen den Haftzonen eine Abdeckschicht (228) auf die Kleberschicht oder die korrespondierende Position an der Oberfläche der Leiterfolie nach einem vorgegebenen Muster aufgetragen wird, wobei vorzugsweise Zwischenbereiche zwischen den Haftzonen mit einem Lack oder einer Tinte abgedeckt werden oder worin bei der Nachbehandlung Zwischenbereiche zwischen den Haftzonen mittels Laserstrahlung behandelt werden, wobei vorzugsweise in den Zwischenbereichen Klebermaterial der Kleberschicht lokal mindestens teilweise abgetragen wird.

5. Verfahren nach einem der Ansprüche 2 bis 4, worin aus Kleber bestehende Anteile von Registermarken (230) gleichzeitig mit dem Kleberauftrag auf dem Substrat (200) erzeugt werden, vorzugsweise dadurch, dass ein Druckwerk zum Auftragen des Klebers gleichzeitig zum Drucken von Anteilen der Registermarken genutzt wird.

6. Verfahren nach einem der vorhergehenden Ansprüche, worin zum Strukturieren der Leiterfolie mittels eines Laserbearbeitungssystems Laserstrahlung entlang der Grenzen der ersten Bereiche eingestrahlt wird, wobei vorzugsweise eine Selbstkalibrierung des Laserbearbeitungssystems mit folgenden Schritten durchgeführt wird:
Erzeugen mindestens einer Lasermarkierung (155) im Bereich einer auf dem Substrat angebrachten Registermarke (230);
Ortsauflösende Erfassung des Bereichs der Registermarke und der Lasermarkierung zur Bestimmung einer relativen Abweichung der Lasermarkierung zu der Registermarke;
Bestimmen mindestens eines Abweichungsparameters, der die Abweichung der Lasermarkierung zu der Registermarke repräsentiert; und
Steuern des Laserbearbeitungssystems unter Berücksichtigung des Abweichungsparameters.

7. Verfahren nach einem der vorhergehenden Ansprüche, worin nach Abschluss der Strukturierungsoperation Folienstücke (143) aus lateral ausgedehnten zweiten Bereichen (250) mittels einer Reinigungseinrichtung in einer Reinigungsoperation dadurch entfernt werden, dass die Folienstücke an eine Außenfläche (163) eines bewegten Förderelements (164) übertragen und mittels des Förderelements von den Haftzonen abgelöst und zur Weiterverarbeitung abtransportiert werden, wobei vorzugsweise die Folienstücke (143) in einem Ansaugabschnitt (172) des Förderelements (162) durch Erzeugung eines Unterdrucks zwischen den Folienstücken und der Außenfläche (163) an die Außenfläche angesaugt und mittels des Förderelements von den Haftzonen abgelöst und zur Weiterverarbeitung abtransportiert werden, wobei vorzugsweise die an der Außenfläche angesaugten Folienstücke (143) durch das Förderelement in den Bereich eines Freigabeabschnitts (174) transportiert und im Freigabeabschnitt durch Erzeugung eines Überdrucks zwischen der Außenfläche und den Stücken aktiv von dem Förderelement freigegeben werden.

8. Anlage zum Herstellen eines Mehrschichtelements mit einem Substrat und mindestens einer mit dem Substrat flächig verbundenen Leiterstruktur, die erste Bereiche aus elektrisch leitenden Material aufweist, welches nach einem vorgegebenen Muster vorliegt, wobei zwischen den ersten Bereichen elektrisch nicht leitende zweite Bereiche liegen, wobei eine Leiterfolie (142) in den ersten Bereichen fest mit dem Substrat verbunden ist, insbesondere zum Herstellen von RFID-Antennen in einem Rolle-zu-Rolle-Verfahren, **gekennzeichnet durch**
Einrichtungen zum Verbinden der Leiterfolie (142) mit dem Substrat derart, dass in lateral ausgedehnten zweiten Bereichen ein partieller Haftkontakt zwischen dem Substrat und der Leiterfolie an einer Vielzahl von Haftzonen (224) existiert; einer Einrichtung (140) zum Strukturieren der Leiterfolie **durch** Schneiden der Leiterfolie entlang von Grenzen der ersten Bereiche; und
einer Reinigungseinrichtung (160) zum Entfernen von Folienstücken (143) der Leiterfolie aus lateral ausgedehnten zweiten Bereichen unter Auflösen des partiellen Haftkontakts zwischen dem Substrat und der Leiterfolie.

9. Anlage nach Anspruch 8, worin die Einrichtungen zum Verbinden der Leiterfolie mit dem Substrat eine Kleberauftragseinrichtung (130) zum Auftragen einer Kleberschicht auf das Substrat und/oder auf die Leiterfolie aufweisen, wobei die Kleberauftragseinrichtung vorzugsweise eine Flexodruckwerk oder ein Strahldruckwerk zum Aufbringen einer lateral strukturierten Kleberschicht aufweist.

10. Anlage nach Anspruch 8 oder 9, worin die Reinigungseinrichtung (160) ein mittels eines Antriebs bewegbares Förderelement (164) mit einer zum Zusammenwirken mit den Folienstücken vorgesehenen Außenfläche (163) sowie eine Einrichtung zur Erzeugung einer Anziehungskraft zwischen der Außenfläche und den Folienstücken aufweist, wobei vorzugsweise das Förderelement von der Außenfläche zu einer Innenfläche durchgehende Gasdurchlasskanäle zur Erzeugung eines Unterdrucks zwischen der Außenfläche und den Folienstücken aufweist.

11. Anlage nach Anspruch 10, worin das Förderelement eine Walze (164) oder Förderband ist.

12. Anlage nach einem der Ansprüche 8 bis 11, worin die Reinigungseinrichtung (160) eine Reinigungswalze mit einer mittels eines Antriebs drehbaren Außenhülse (164) als Förderelement aufweist, wobei die Außenhülse von der Außenfläche (163) zu einer Innenfläche durchgehende Gasdurchlasskanäle aufweist und im Inneren der Außenhülse ein Druckkammersystem angeordnet ist, welches Druckkammern aufweist, die über Anschlüsse an eine Pumpe angeschlossen oder anschließbar sind, um Unterdruck oder Überdruck in einer Druckkammer zu erzeugen, wobei die Druckkammern zur Außenwalze hin offen und gegenüber dieser an den Rändern abgedichtet sind, wobei die Druckkammern derart betreibbar sind, dass die Außenwalze in einem Ansaugabschnitt (172) eine ansaugende Wirkung auf Folienstücke ausüben kann und in einem Freigabeabschnitt (174) ein Überdruck in der zugeordneten Druckkammer zu einer abstoßenden Wirkung zwischen der Außenwalze und anhaftenden Folienstücken führt.

13. Anlage nach einem der Ansprüche 8 bis 12, worin die Einrichtung (140) zum Strukturieren der Leiterfolie ein Laserbearbeitungssystem aufweist, wobei das Laserbearbeitungssystem vorzugsweise zur Durchführung einer Selbstkalibrierung konfiguriert ist, die folgenden Schritte aufweist:
Erzeugen mindestens einer Lasermarkierung (155) im Bereich einer auf dem Substrat angebrachten Registermarke (230);
Ortsauflösende Erfassung des Bereichs der Registermarke und der Lasermarkierung zur Bestimmung einer relativen Abweichung der Lasermarkierung zu der Registermarke;
Bestimmen mindestens eines Abweichungsparameters, der die Abweichung der Lasermarkierung zu der Registermarke repräsentiert; und
Steuern des Laserbearbeitungssystems unter Berücksichtigung des Abweichungsparameters.

14. Mehrschichtelement, insbesondere RFID-Antenne, hergestellt oder herstellbar durch ein Verfahren nach einem der Ansprüche 1 bis 7, wobei das Mehrschichtelement ein Substrat (200) und mindestens eine mit dem Substrat mittels einer Kleberschicht (220) flächig verbundene Leiterstruktur (145) aufweist, die erste Bereiche aus elektrisch leitenden Material aufweist, welches nach einem vorgegebenen Muster auf der Kleberschicht (220) vorliegt, wobei angrenzend an erste Bereiche elektrisch nicht leitende zweite Bereiche (250) liegen, wobei in lateral ausgedehnten zweiten Bereichen eine Vielzahl von Haftzonen der Kleberschicht nach einem vorgegebenen Muster verteilt vorliegt.

15. Mehrschichtelement nach Anspruch 14, **dadurch gekennzeichnet, dass** die Haftzonen (224) in lateral ausgedehnten zweiten Bereichen (250) ein Punktemuster oder ein Linienmuster bilden und/oder worin ein Flächenanteil der Haftzonen (224) innerhalb der lateral ausgedehnten Bereiche zwischen 2% und 80%, insbesondere zwischen ca. 5% und ca. 50% liegt.

## Claims

1. A method for producing a multilayer element with a substrate and at least one conductor structure connected in an areal manner to the substrate, which has first regions of electrically conductive material, which is present in accordance with a prescribed pattern, wherein electrically non-conductive second regions lie between the first regions, wherein a conductor foil (142) is firmly connected to the substrate in the first regions, in particular for producing RFID antennas in a roller-to-roller process, **characterized by** the following steps:
connecting the conductor foil (142) to the substrate (200) in such a way that a partial bonding contact between the substrate and the conductor foil is created at a multiplicity of bonding zones (224) in laterally extended second regions;
structuring the conductor foil by cutting the conductor foil along boundaries of the first regions; and
removing contiguous pieces of foil (143) of the conductor foil from laterally extended second regions (250) by releasing the partial bonding contact between the substrate and the conductor foil.

2. The method according to claim 1, wherein the conductor foil (142) is connected to the substrate (200) by means of a layer of adhesive (220) lying in between.

3. The method according to claim 2, wherein the adhesive layer (220) is created in such a way that the bonding zones (224) in laterally extended second regions (250) form a pattern of points or a pattern of lines and/or in such a way that an area fraction of the bonding zones (224) within the laterally extended second regions lies between 2% and 80%, in particular between about 5% and about 50%, or wherein before the connecting of the conductor foil to the substrate, a laterally structured layer of adhesive is applied to the substrate or to the conductor foil, adhesive material being applied over the full surface area in the first regions (240) and partially, in accordance with a prescribed pattern, in laterally extended second regions (250), for creating the bonding zones (224), preferably by means of a jet printing process or by a flexographic printing process.

4. The method according to claim 2, wherein before the connecting of the conductor foil to the substrate, in a first partial operation a layer of adhesive is applied to the substrate or the conductor foil over the full surface area in first and second regions, and after that, in a second partial operation, intermediate regions (226) of the layer of adhesive with reduced bonding force, or without any bonding force, are thereby created by a post-treatment within the laterally extended second regions (250) between the bonding zones (224) provided, wherein preferably in the post-treatment, a covering layer (228) is applied in the intermediate regions between the bonding zones to the layer of adhesive or the corresponding position on the surface of the conductor foil in accordance with a prescribed pattern, intermediate regions between the bonding zones preferably being covered with a lacquer or an ink, or wherein in the post-treatment, intermediate regions between the bonding zones are treated by means of laser radiation, adhesive material of the layer of adhesive preferably being at least partially removed locally in the intermediate regions.

5. The method according to any of claims 2 to 4, wherein portions of register marks (230) consisting of adhesive are created on the substrate (200) simultaneously with the application of adhesive, preferably by a printing unit for applying the adhesive being used at the same time for printing portions of the register marks.

6. The method according to any of the preceding claims, wherein for structuring the conductor foil by means of a laser machining system, laser radiation is radiated in along the boundaries of the first regions, wherein preferably a self-calibration of the laser machining system is performed, comprising the following steps:
creating at least one laser marking (155) in the region of a register mark (230) provided on the substrate;
detecting in a spatially resolving manner the region of the register mark and of the laser marking for the determination of a relative deviation of the laser marking in relation to the register mark;
determining at least one deviation parameter that represents the deviation of the laser marking in relation to the register mark; and
controlling the laser machining system while taking into account the deviation parameter.

7. The method according to any of the preceding claims, wherein, after completion of the structuring operation, pieces of foil (143) are removed from laterally extended second regions (250) by means of a cleaning device in a cleaning operation in that the pieces of foil are transferred to an outer surface (163) of a moving transporting element (164) and detached from the bonding zones by means of the transporting element and transported away for further processing, wherein preferably the pieces of foil (143) are sucked onto the outer surface by creating a negative pressure between the pieces of foil and the outer surface (163) in a suction-attaching portion (172) of the transporting element (162) and detached from the bonding zones by means of the transporting element and transported away for further processing, the pieces of foil (143) sucked onto the outer surface preferably being transported by the transporting element into the region of a releasing portion (174) and actively released from the transporting element in the releasing portion by creating a positive pressure between the outer surface and the pieces.

8. A system for producing a multilayer element with a substrate and at least one conductor structure connected in an areal manner to the substrate, which has first regions of electrically conductive material, which is present in accordance with a prescribed pattern, wherein electrically non-conductive second regions lie between the first regions, wherein a conductor foil (142) is firmly connected to the substrate in the first regions, in particular for producing RFID antennas in a roller-to-roller process, **characterized by**
devices for connecting the conductor foil (142) to the substrate in such a way that a partial bonding contact between the substrate and the conductor foil exists at a multiplicity of bonding zones (224) in laterally extended second regions;
a device (140) for structuring the conductor foil by cutting the conductor foil along boundaries of the first regions; and
a cleaning device (160) for removing pieces of foil (143) of the conductor foil from laterally extended second regions by releasing the partial bonding contact between the substrate and the conductor foil.

9. The system according to claim 8, wherein the devices for connecting the conductor foil to the substrate have an adhesive applying device (130) for applying a layer of adhesive to the substrate and/or to the conductor foil, the adhesive applying device preferably having a flexographic printing unit or a jet printing unit for applying a laterally structured layer of adhesive.

10. The system according to claim 8 or 9, wherein the cleaning device (160) has a transporting element (164) that can be moved by means of a drive and has an outer surface (163) intended for interacting with the pieces of foil and also a device for creating a force of attraction between the outer surface and the pieces of foil, the transporting element preferably having gas passages passing through from the outer surface to an inner surface for creating a negative pressure between the outer surface and the pieces of foil.

11. The system according to claim 10, wherein the transporting element is a roller (164) or a conveyor belt.

12. The system according to any of claims 8 to 11, wherein the cleaning device (160) has as a transporting element a cleaning roller with an outer sleeve (164) that can be turned by means of a drive, the outer sleeve having gas passages passing through from the outer surface (163) to an inner surface and there being arranged in the interior of the outer sleeve a pressure chamber system, which has pressure chambers that are connected or can be connected by way of connections to a pump, in order to create negative pressure or positive pressure in a pressure chamber, the pressure chambers being open toward the outer roller and sealed off with respect to it at the peripheries, it being possible for the pressure chambers to be operated in such a way that in a suction-attaching portion (172) the outer roller can exert a sucking effect on pieces of foil and in a releasing portion (174) a positive pressure in the assigned pressure chamber leads to a repelling effect between the outer roller and the attached pieces of foil.

13. The system according to any of claims 8 to 12, wherein the device (140) for structuring the conductor foil has a laser machining system, the laser machining system preferably being configured for carrying out a self-calibration, which comprises the following steps:
creating at least one laser marking (155) in the region of a register mark (230) provided on the substrate;
detecting in a spatially resolving manner the region of the register mark and of the laser marking for the determination of a relative deviation of the laser marking in relation to the register mark;
determining at least one deviation parameter that represents the deviation of the laser marking in relation to the register mark; and
controlling the laser machining system while taking into account the deviation parameter.

14. A multilayer element, in particular an RFID antenna, that is produced or can be produced by a method according to any of claims 1 to 7, wherein the multilayer element has a substrate (200) and at least one conductor structure (145) connected in an areal manner to the substrate by means of a layer of adhesive (220), which conductor structure has first regions of electrically conductive material, which is present on the layer of adhesive (220) in accordance with a prescribed pattern, wherein electrically non-conductive second regions (250) lie adjacent to first regions, wherein a multiplicity of bonding zones of the adhesive layer are present in laterally extended second regions in a distributed manner in accordance with a prescribed pattern.

15. The multilayer element according to claim 14, **characterized in that** the bonding zones (224) in laterally extended second regions (250) form a pattern of points or a pattern of lines and/or wherein an area fraction of the bonding zones (224) within the laterally extended regions is between 2% and 80%, in particular between about 5% and about 50%.

## Revendications

1. Procédé de fabrication d'un élément multicouche présentant un substrat et au moins une structure conductrice reliée à plat au substrat et présentant des premières parties en matériau électriquement conducteur qui se présentent selon un motif prédéterminé, des deuxièmes parties électriquement non conductrices étant situées entre les premières parties,
une feuille conductrice (142) étant raccordée solidairement au substrat dans les premières parties, en particulier pour former des antennes RFID dans un procédé rouleau sur rouleau,
**caractérisé par** les étapes suivantes :
liaison de la feuille conductrice (142) avec le substrat (200) de telle sorte qu'un contact adhésif partiel soit formé en plusieurs zones adhésives (224) dans des deuxièmes parties s'étendant latéralement entre le substrat et la feuille conductrice,
structuration de la feuille conductrice par découpe de la feuille conductrice le long des frontières des premières parties et
enlèvement de morceaux continus (143) de feuille conductrice dans les deuxièmes parties (250) s'étendant latéralement, par suppression du contact adhésif partiel entre le substrat et la feuille conductrice.

2. Procédé selon la revendication 1, dans lequel la feuille conductrice (142) est reliée au substrat (200) au moyen d'une couche intermédiaire adhésive (220).

3. Procédé selon la revendication 2, dans lequel la couche adhésive (220) est formée par le fait que les zones adhésives (224) forment un motif de points ou un motif de lignes dans les deuxièmes parties (250) s'étendant latéralement et/ou par le fait qu'une partie de la surface des zones adhésives (224) située à l'intérieur des deuxièmes parties s'étendant latéralement en représente entre 2 % et 80 % et en particulier entre environ 5 % et environ 50 %, ou dans lequel une couche adhésive structurée latéralement est appliquée sur le substrat ou sur la feuille conductrice avant la liaison de la feuille conductrice avec le substrat, le matériau adhésif étant appliqué sur toute la surface des premières parties (240) et dans les deuxièmes parties (250) s'étendant latéralement pour former les zones adhésives (224), en partie selon un motif prédéterminé, de préférence au moyen d'un procédé d'impression par jet ou par un procédé de flexographie.

4. Procédé selon la revendication 2, dans lequel une couche d'adhésif est appliquée sur toute la surface des premières et des deuxièmes parties du substrat ou de la feuille conductrice dans une première opération partielle qui précède la liaison de la feuille conductrice avec le substrat et ensuite des parties intermédiaires (226) de couche adhésive dont la force adhésive est réduite ou supprimée sont formées dans une deuxième opération partielle de post-traitement entre les zones adhésives (224) prévues à l'intérieur des deuxièmes parties (250) s'étendant latéralement, et lors du post-traitement, dans les parties intermédiaires situées entre les zones adhésives, une couche de recouvrement (228) est de préférence appliquée sur la couche d'adhésif ou sur la position correspondante de la surface de la feuille conductrice selon un motif prédéterminé, les parties intermédiaires entre les zones adhésives étant de préférence recouvertes d'un vernis ou d'une encre ou lors du post-traitement, des parties intermédiaires entre les zones adhésives sont traitées au moyen d'un rayonnement laser, le matériau adhésif de la couche adhésive étant enlevé au moins en partie localement, de préférence dans les parties intermédiaires.

5. Procédé selon l'une des revendications 2 à 4, dans lequel des parties constituées d'adhésif sont formées par des repères d'alignement (230) en même temps que l'application d'adhésif sur le substrat (200), de préférence en utilisant une machine d'impression qui applique l'adhésif en même temps qu'elle imprime des parties des repères d'alignement.

6. Procédé selon l'une des revendications précédentes, dans lequel pour structurer la feuille conductrice au moyen d'un système de traitement au laser, un rayonnement laser est projeté le long des frontières des premières parties, un auto-étalonnage du système de traitement par laser présentant les étapes suivantes étant de préférence réalisé :
formation d'au moins un repère laser (155) au niveau d'un repère alignment (230) appliqué sur le substrat,
saisie à résolution spatiale de la zone du repère d'alignement et du repère laser pour déterminer l'écart relatif entre le repère laser et le repère d'alignement,
détermination d'au moins un paramètre d'écart qui représente l'écart entre le repère laser et le repère d'alignement et
commande du système de traitement laser en tenant compte du paramètre d'écart.

7. Procédé selon l'une des revendications précédentes, dans lequel après que l'opération de structuration est terminée, des morceaux (143) de feuille constitués de deuxièmes parties (250) à l'extension latérale sont enlevés dans une opération de nettoyage au moyen d'un dispositif de nettoyage, par le fait que les morceaux de feuille sont transférés sur une surface extérieure (163) d'un élément de transport (164) en déplacement, sont enlevés des zones adhésives au moyen de l'élément de transport avant d'être évacués pour poursuivre leur traitement, les morceaux (143) de feuille étant de préférence aspirés dans une partie d'aspiration (172) de l'élément de transport (162) par formation d'une dépression entre les morceaux de feuille et la surface extérieure (163) sur la surface extérieure et sont enlevés des zones adhésives au moyen de l'élément de transport pour être envoyés vers la poursuite de leur traitement, les morceaux de feuille (143) aspirés sur la surface extérieure étant de préférence transportés par l'élément de transport jusqu'au niveau d'une section de libération (174) et libérés activement de l'élément de transport dans la section de libération, par formation d'une surpression entre la surface extérieure et les morceaux.

8. Installation de fabrication d'un élément multicouche présentant un substrat, et au moins une structure conductrice reliée à plat au substrat et présentant des premières parties en matériau électriquement conducteur qui se présentent selon un motif prédéterminé, des deuxièmes parties électriquement non conductrices étant situées entre les premières parties,
une feuille conductrice (142) étant raccordée solidairement au substrat dans les premières parties, en particulier pour former des antennes RFID dans un procédé rouleau sur rouleau,
**caractérisée par**
des dispositifs permettant de relier la feuille conductrice (142) au substrat de telle sorte qu'un contact adhésif partiel soit formé en plusieurs zones adhésives (224) dans des deuxièmes parties s'étendant latéralement entre le substrat et la feuille conductrice,
un dispositif (140) de structuration de la feuille conductrice par découpe de la feuille conductrice le long des frontières des premières parties et
un dispositif de nettoyage (160) qui enlève des morceaux (143) de feuille conductrice dans les deuxièmes parties s'étendant latéralement, par suppression du contact adhésif partiel entre le substrat et la feuille conductrice.

9. Installation selon la revendication 8, dans laquelle les dispositifs de liaison de la feuille conductrice au substrat présentent un dispositif (130) d'application d'adhésif qui applique une couche d'adhésif sur le substrat et/ou sur la feuille conductrice, le dispositif d'application d'adhésif présentant de préférence un système de flexographie ou un système d'impression au jet qui applique une couche d'adhésif structurée latéralement.

10. Installation selon les revendications 8 ou 9, dans laquelle le dispositif de nettoyage (160) présente un élément de transport (164) apte à être déplacé au moyen d'un entraînement et présentant une surface extérieure (163) prévue pour coopérer avec les morceaux de feuille, ainsi qu'un dispositif qui forme une force d'attraction entre la surface extérieure et les morceaux de feuille, l'élément de transport présentant de préférence des canaux de passage de gaz qui le traversent de la surface extérieure à une surface intérieure, pour former une dépression entre la surface extérieure et les morceaux de feuille.

11. Installation selon la revendication 10, dans laquelle l'élément de transport est un cylindre (164) ou une bande transporteuse.

12. Installation selon l'une des revendications 8 à 11, dans laquelle le dispositif de nettoyage (160) présente un cylindre de nettoyage doté d'une enveloppe extérieure (164) entraînée en rotation et servant d'élément de transport, l'enveloppe extérieure présentant des canaux de passage de gaz allant de la surface extérieure (163) jusqu'à une surface intérieure et un système à chambre sous pression étant disposé à l'intérieur de l'enveloppe extérieure et présentant des chambres sous pression qui sont raccordées ou peuvent être raccordées à une pompe par des raccords pour former une dépression ou une surpression dans une chambre sous pression, les chambres sous pression étant ouvertes en direction du cylindre extérieur et étant fermées de manière hermétique par rapport à ce dernier sur les bords, les chambres sous pression pouvant être utilisées de telle sorte que le cylindre extérieur puisse exercer dans une partie d'aspiration (172) un effet d'aspiration sur des morceaux de feuille et dans une section de libération (174), une surpression dans la chambre sous pression associée, pour obtenir un effet d'expulsion entre le cylindre extérieur et des morceaux de feuille qui y adhèrent.

13. Installation selon l'une des revendications 8 à 12, dans laquelle le dispositif (140) de structuration de la feuille conductrice présente un système de traitement au laser, le système de traitement au laser étant de préférence configuré pour exécuter un auto-étalonnage qui présente les étapes suivantes :
formation d'au moins un repère laser (155) au niveau d'un repère d'alignement (230) appliqué sur le substrat,
saisie à résolution spatiale de la zone du repère d'alignement et du repère laser pour déterminer l'écart relatif entre le repère laser et le repère d'alignement,
détermination d'au moins un paramètre d'écart qui représente l'écart entre le repère laser et le repère d'alignement et
commande du système de traitement laser en tenant compte du paramètre d'écart.

14. Elément multicouche, en particulier antenne RFID, fabriqué ou apte à être fabriqué avec un procédé selon l'une des revendications 1 à 7, et dans lequel l'élément multicouche présente un substrat (200) et au moins une structure conductrice (145) reliée à plat au substrat au moyen d'une couche adhésive (220) présentant des premières parties en matériau électriquement conducteur qui se présentent selon un motif prédéterminé sur la couche adhésive (220), des deuxièmes parties électriquement non conductrices (250) étant adjacentes aux premières parties, plusieurs zones adhésives de la couche adhésive étant réparties selon un motif prédéterminé dans des deuxièmes parties s'étendant latéralement.

15. Elément multicouche selon la revendication 14, **caractérisé en ce que** les zones adhésives (224) forment dans les deuxièmes parties (250) à extension latérale un motif de points ou un motif de lignes et/ou dans lequel la partie de surface des zones adhésives (224) située à l'intérieur des parties à extension latérale en représente entre 2 % et 80 % et en particulier entre environ 5 % et environ 50 %.
